# EUROPEAN PATENT APPLICATION

(11) **EP 4 844 760 A1**
(43) Date of publication of application: **25.11.2026**
(21) Application number: 26156647.5
(22) Date of filing: 05.02.2026
(51) Int. Cl.: G11C 5/14, G05F 1/46, G06F 1/3234

(54) **MEMORY DEVICE INCLUDING VOLTAGE REGULATORS**

(30) Priority: 19.05.2025 KR 20250064696
(71) Applicant: SK hynix Inc., Bubal-eub Icheon-si Gyeonggi-do 17336 (KR)
(72) Inventor: LEE, Jeong, 17336 Icheon-si, Gyeonggi-do (KR); KIM, Sun Hak, 17336 Icheon-si, Gyeonggi-do (KR); JEON, Jun Tak, 17336 Icheon-si, Gyeonggi-do (KR); HWANG, Jun Sun, 17336 Icheon-si, Gyeonggi-do (KR)
(74) Representative: Isarpatent

(57) **Abstract**

A memory device includes a plurality of planes, a control circuit, and a plurality of voltage regulator groups. The plurality of voltage regulator groups corresponds to one of the plurality of planes and the control circuit and is configured to supply a voltage used in data transfer associated with the plurality of planes and the control circuit. The control circuit is configured to control group current consumption levels of the plurality of voltage regulator groups for each operation interval according to a command and an address.

## Description

### BACKGROUND

### 1. TECHNICAL FIELD

**The** present disclosure generally relates to a memory device, including but not limited to a memory device including voltage regulators.

### 2. RELATED ART

A semiconductor device is a component of electronic devices and has a wide range of modern applications, for example, semiconductor devices can be utilized in technologies or applications such as computing, communications, artificial intelligence, and memory. The memory device includes components such as transistors, diodes, and integrated circuits (ICs).

As environmental issues such as Environmental, Social, and Governance (ESG) and carbon neutrality are emerging, the demand for low power consumption is gradually increasing not only in large-scale power consumption systems such as data centers but also in semiconductor memory devices. Improved power efficiency, high-performance, and high-speed data input/output operations are features advantageous in memory devices.

### SUMMARY

In an embodiment, a memory device may include a plurality of planes, a control circuit, and a plurality of voltage regulator groups. Each of the plurality of voltage regulator groups may correspond to one of the plurality of planes and the control circuit, and may be configured to supply a voltage used in data transfer associated with the plurality of planes and the control circuit. The control circuit may be configured to control group current consumption levels of the plurality of voltage regulator groups for each operation interval according to a command and an address.

In an embodiment, a memory device may include a plurality of voltage regulators and a control circuit. The plurality of voltage regulators may be configured to supply a voltage used in data transfer. The control circuit may be configured to, during an operation performed in response to a command, adjust a quantity of voltage regulators activated among the plurality of voltage regulators during each operation interval of the operation.

In an embodiment, a memory device may include a plurality of voltage regulators and a circuit. The plurality of voltage regulators may be configured to supply a voltage used in data transfer. The circuit may be configured to, during an operation performed in response to a command, control current consumption level of each voltage regulator activated among the plurality of voltage regulators during each operation interval of the operation.

### BRIEF DESCRIPTION OF THE DRAWINGS

FIG. 1 is a block diagram illustrating a memory device according to an embodiment of the present disclosure.
FIG. 2A is a block diagram illustrating voltage regulator groups included in a voltage supply circuit according to an embodiment of the present disclosure.
FIG. 2B is a table illustrating activation levels according to enable signals according to an embodiment of the present disclosure.
FIG. 3A is a circuit diagram illustrating a voltage regulator according to an embodiment of the present disclosure.
FIG. 3B is a table illustrating current consumption levels according to a current control signal according to an embodiment of the present disclosure.
FIG. 4 is a table including group current consumption levels of a voltage regulator group according to an embodiment of the present disclosure.
FIG. 5A is a block diagram illustrating a control circuit according to an embodiment of the present disclosure.
FIG. 5B is a table illustrating a command flag and internal control signals according to an embodiment of the present disclosure.
FIG. 6 is a table including a command flag and a corresponding high-speed flag or top high-speed flag according to an embodiment of the present disclosure.
FIG. 7 is a block diagram illustrating a voltage regulator control circuit according to an embodiment of the present disclosure.
FIG. 8A to FIG. 8D are circuit diagrams illustrating a main control circuit and sub-control circuits according to an embodiment of the present disclosure.
FIG. 9 is a timing diagram of a data input operation according to an embodiment of the present disclosure.
FIG. 10 is a timing diagram of a data output operation according to an embodiment of the present disclosure.
FIG. 11 to FIG. 14 are diagrams illustrating group current consumption levels for voltage regulator groups according to an embodiment of the present disclosure.
FIG. 15 is a diagram illustrating a circuit between a first voltage regulator and a second voltage regulator according to an embodiment of the present disclosure.
FIG. 16A to FIG. 16C are circuit diagrams illustrating sub-control circuits according to an embodiment of the present disclosure.
FIG. 17 is a timing diagram illustrating a first current control signal output according to an embodiment of the present disclosure.
FIG. 18 is a circuit diagram illustrating a voltage regulator according to an embodiment of the present disclosure.
FIG. 19 is a timing diagram of a prefetch operation according to an embodiment of the present disclosure.
FIG. 20 is a timing diagram a prefetch operation according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

Terms such as "top," "bottom," "under," "beneath," "over," "on," "low," "lower," "higher," "high," "column," "level," and other terms implying relative spatial relationship or orientation or other relationships are utilized only for the purpose of ease of description or reference to a drawing and are not otherwise limiting.

When one element is identified as "coupled" to another element, the elements may be coupled directly or through at least one intervening element between the elements. When two elements are identified as "directly coupled," one element is directly coupled to the other element without an intervening element between the two elements.

The cross-hatching throughout the figures illustrates corresponding or similar areas between the figures rather than indicating the materials associated with the areas.

Terms such as "first" and "second" are used to distinguish between various elements and do not imply size, order, priority, quantity, or importance of the elements. For example, a first element may be referred to as a second element in one example, and the second element may be referred to as a first element in another example.

Because proper function of a voltage regulator included in a memory device stably supplies power, dynamically changing state of the voltage regulator may be difficult, especially when the memory device includes high-speed operation during low power conditions.

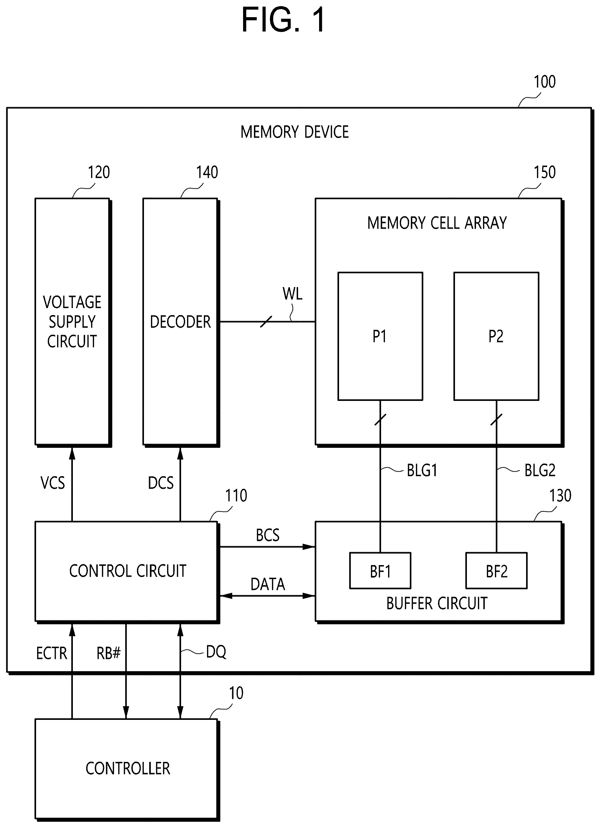

FIG. 1 is a block diagram illustrating a memory device 100 according to an embodiment of the present disclosure.

Referring to FIG. 1, the memory device 100 operates under the control of an external device, for example, a controller 10. The memory device 100 stores data DATA received from the controller 10 by performing a program operation and outputs the stored data DATA to the controller 10 by performing a read operation.

The memory device 100 includes a control circuit 110, a voltage supply circuit 120, a buffer circuit 130, a decoder 140, and a memory cell array 150.

The control circuit 110 receives an external control signal ECTR from the controller 10. The control circuit 110 receives a command, an address, and the data DATA from the controller 10 through input/output lines DQ and outputs the data DATA to the controller 10 through the input/output lines DQ. The control circuit 110 outputs a ready/busy signal RB# to the controller 10.

In response to the signals received from the controller 10, the control circuit 110 controls components of the memory device 100 to perform internal operations, such as a program operation, a read operation, and an erase operation. For example, the control circuit 110 generates voltage control signals VCS to control the voltage supply circuit 120 and outputs the voltage control signals VCS to the voltage supply circuit 120. The control circuit 110 generates a buffer control signal BCS to control the buffer circuit 130 and outputs the buffer control signal BCS to the buffer circuit 130. The control circuit 110 generates a decoder control signal DCS to control the decoder 140 and outputs the decoder control signal DCS to the decoder 140. The control circuit 110 transmits the data DATA received from the controller 10 to the buffer circuit 130 and outputs the data DATA transmitted from the buffer circuit 130 to the controller 10.

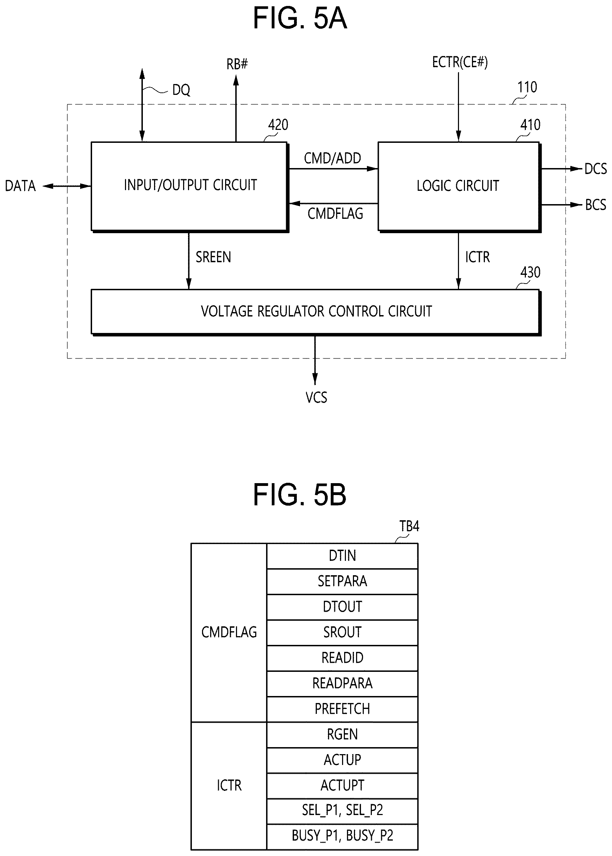

As described with respect to FIG. 5A, the control circuit 110 controls group current consumption levels of a plurality of voltage regulator groups included in the voltage supply circuit 120 for each operation interval based on the command and the address. Each of the plurality of voltage regulator groups includes a plurality of voltage regulators. As the group current consumption level increases, the current consumption of the voltage regulator group increases. To control the group current consumption level of each voltage regulator group, the control circuit 110 adjusts the quantity of voltage regulators activated among the plurality of voltage regulators included in each voltage regulator group during each operation interval when performing an operation in response to the command. To control the group current consumption level of each voltage regulator group, the control circuit 110 controls a current consumption level of each voltage regulator activated in each voltage regulator group. As the current consumption level increases, the current consumption of the voltage regulator increases.

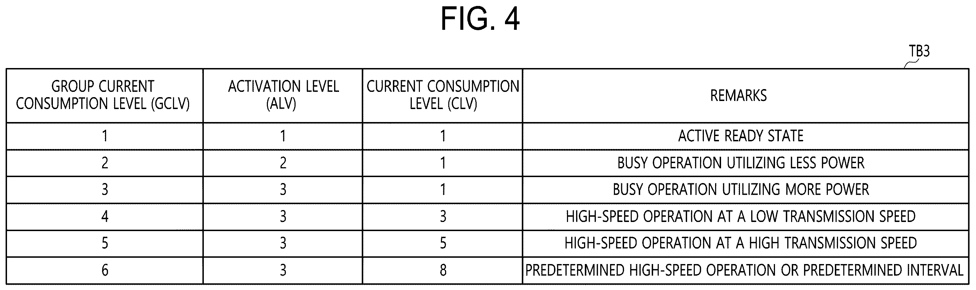

For example, according to a type of the command, the control circuit 110 may determine at least one of an operation interval in which a busy operation is performed and an operation interval in which a high-speed operation is performed and activates fewer of the voltage regulators in the operation interval in which the busy operation is performed than in the operation interval in which the high-speed operation is performed. The control circuit 110 controls voltage regulators activated during the operation interval in which the busy operation is performed to operate at a lower current consumption level than in the operation interval in which the high-speed operation is performed. Accordingly, the memory device 100 manages current consumption by adjusting a quantity of the internal circuits that are activated and may reduce power consumption without performance degradation. The busy operation and the high-speed operation are described, for example, with reference to FIG. 4.

The voltage supply circuit 120 generates various voltages in response to the voltage control signals VCS and outputs the voltages to circuits included in the memory device 100. The voltages output from the voltage supply circuit 120 include a data path voltage supplied to a data path and used in data transfer, a pump voltage supplied to a pump circuit, a logic voltage supplied to the control circuit 110, various reference voltages, and various operation voltages, such as a program voltage, a program pass voltage, a read voltage, a read pass voltage, and an erase voltage.

The buffer circuit 130 include a first buffer BF1 and a second buffer BF2. The first buffer BF1 is coupled to a first plane P1 of memory cells included in the memory cell array 150 through first bit lines BLG1. The second buffer BF2 is coupled to a second plane P2 of memory cells included in the memory cell array 150 through second bit lines BLG2. Each of the first buffer BF1 and the second buffer BF2 receives and stores the data DATA from the control circuit 110 and stores the data DATA in a corresponding plane. Each of the first buffer BF1 and the second buffer BF2 stores the data DATA read from the corresponding plane to output the data DATA to the control circuit 110. The first buffer BF1 and the second buffer BF2 operate in response to the buffer control signal BCS. In an embodiment, the buffer circuit 130 includes a quantity of buffers corresponding to the quantity of planes included in the memory cell array 150.

The decoder 140 is coupled to the first plane P1 and the second plane P2 through word lines WL. In response to the decoder control signal DCS, the decoder 140 controls operations of the first plane P1 and the second plane P2 by applying voltages to the word lines WL.

The memory cell array 150 includes the first plane P1 and the second plane P2. Each of the first plane P1 and the second plane P2 includes one or more memory blocks. Each memory block includes memory cells in which the data DATA are stored. A memory block is a unit in which the control circuit 110 performs an erase operation. One or more memory blocks included in the same plane may be coupled to the same buffer through corresponding bit lines.

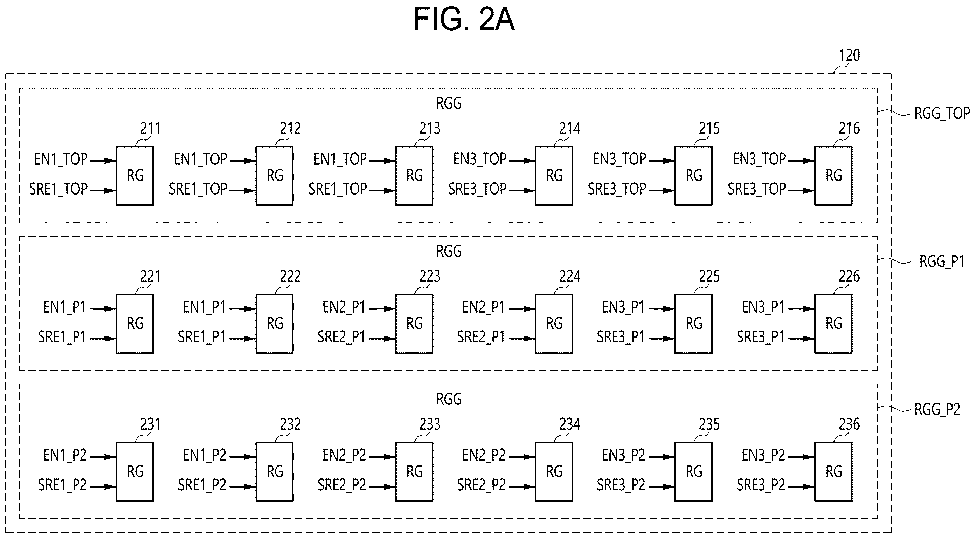

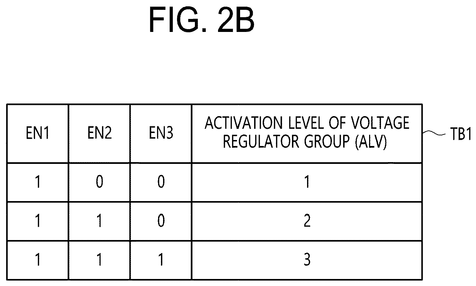

FIG. 2A is a block diagram illustrating a top voltage regulator group RGG_TOP, a first plane voltage regulator group RGG_P1, and a second plane voltage regulator group RGG_P2, included in a voltage supply circuit 120, and FIG. 2B is a table TB1 including activation levels ALV according to a first enable signal EN1 to a third enable signal EN3.

Referring to FIG. 2A, the voltage supply circuit 120 includes the top voltage regulator group RGG_TOP, the first plane voltage regulator group RGG_P1, and the second plane voltage regulator group RGG_P2. Each of the top voltage regulator group RGG_TOP, the first plane voltage regulator group RGG_P1, and the second plane voltage regulator group RGG_P2 includes, for example, six voltage regulators RG. Each voltage regulator RG is a low dropout (LDO) voltage regulator in an embodiment, although a type of the voltage regulator RG may be other than an LDO voltage regulator. Output nodes of the voltage regulators RG included in the top voltage regulator group RGG_TOP, the first plane voltage regulator group RGG_P1, and the second plane voltage regulator group RGG_P2 are coupled in common and may output the same output voltage. For example, an output voltage output from each voltage regulator RG may be a data path voltage supplied to a data path. The data path includes a path through which data is transmitted or processed.

The top voltage regulator group RGG_TOP, the first plane voltage regulator group RGG_P1, and the second plane voltage regulator group RGG_P2 correspond to the control circuit 110, the first plane P1, and the second plane P2, respectively. Each voltage regulator group RGG is disposed close to or within a region of a corresponding circuit. Accordingly, a data path within each region receives the data path voltage from the corresponding voltage regulator group RGG. For example, the first plane voltage regulator group RGG_P1 is disposed close to the first plane P1 and supplies the data path voltage to the data path coupled to the first plane P1 rather than being supplied by other voltage regulator groups RGG_TOP and RGG_P2. The data path coupled to the first plane P1 includes the first buffer BF1. The data path coupled to the second plane P2 includes the second buffer BF2. The data path coupled to the control circuit 110 includes a data path coupled between the first buffer BF1 and the second buffer BF2 and the controller 10.

Among voltage regulators 211 to 216 included in the top voltage regulator group RGG_TOP, some, for example, three voltage regulators 211 to 213, each receive a first enable signal EN1_TOP and a first current control signal SRE1_TOP. Each of the other voltage regulators 214 to 216 included in the top voltage regulator group RGG_TOP receive a third enable signal EN3_TOP and a third current control signal SRE3_TOP.

Among voltage regulators 221 to 226 included in the first plane voltage regulator group RGG_P1, some, for example, two voltage regulators 221 and 222, each receive a first enable signal EN1_P1 and a first current control signal SRE1_P1. Another set of two voltage regulators 223 and 224 each receives a second enable signal EN2_P1 and a second current control signal SRE2_P1. Each of a third set of voltage regulators 225 and 226 receives a third enable signal EN3_P1 and a third current control signal SRE3_P1.

Among voltage regulators 231 to 236 included in the second plane voltage regulator group RGG_P2, some, for example, two voltage regulators 231 and 232, each receive a first enable signal EN1_P2 and a first current control signal SRE1_P2. Another set of two voltage regulators 233 and 234 each receive a second enable signal EN2_P2 and a second current control signal SRE2_P2. Each of a third set of voltage regulators 235 and 236 receives a third enable signal EN3_P2 and a third current control signal SRE3_P2.

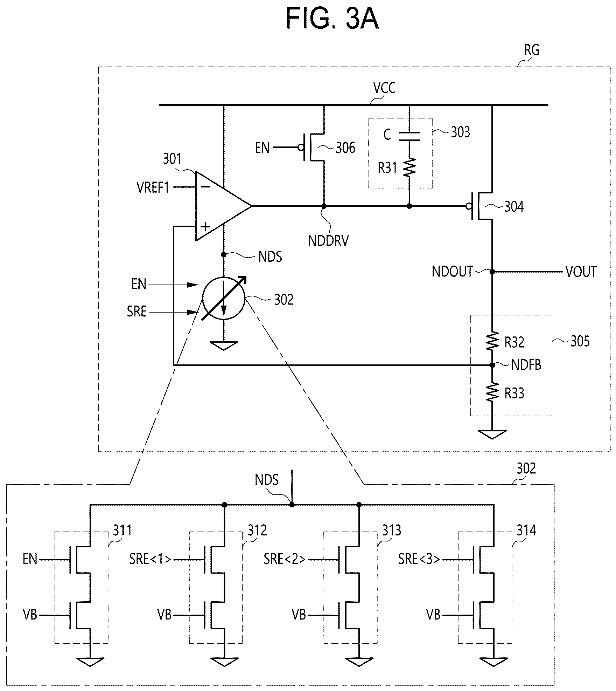

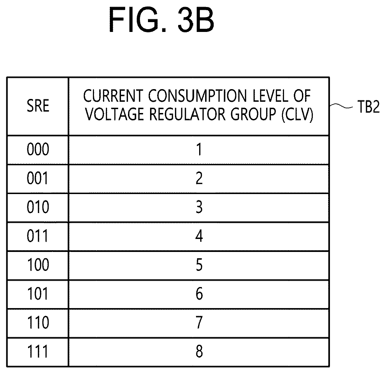

The first enable signals EN1_TOP, EN1_P1, and EN1_P2, the second enable signals EN2_P1 and EN2_P2, the third enable signals EN3_TOP, EN3_P1, and EN3_P2, the first current control signals SRE1_TOP, SRE1_P1, and SRE1_P2, the second current control signals SRE2_P1 and SRE2_P2, and the third current control signals SRE3_TOP, SRE3_P1, and SRE3_P2 are included in the voltage control signals VCS of FIG. 1. Each of the first enable signals EN1_TOP, EN1_P1, and EN1_P2, the second enable signals EN2_P1 and EN2_P2, and the third enable signals EN3_TOP, EN3_P1, and EN3_P2 is a signal that activates a corresponding voltage regulator RG. Each of the first current control signals SRE1_TOP, SRE1_P1, and SRE1_P2, the second current control signals SRE2_P1 and SRE2_P2, and the third current control signals SRE3_TOP, SRE3_P1, and SRE3_P2 is a signal that controls a current consumption level of a corresponding voltage regulator RG, and the first current control signals SRE1_TOP, SRE1_P1, and SRE1_P2, the second current control signals SRE2_P1 and SRE2_P2, and the third current control signals SRE3_TOP, SRE3_P1, and SRE3_P2 are described with reference to FIG. 3A and FIG. 3B.

Referring to table TB1 of FIG. 2B, each voltage regulator group RGG operates in one of activation levels ALV 1, ALV 2, and ALV 3 according to a corresponding first enable signal EN1, a second enable signal EN2, and a third enable signal EN3. The first enable signal EN1, the second enable signal EN2, and the third enable signal EN3 at logic high level 1 indicates an activated state and at logic low level 0 indicates a deactivated state.

When the first enable signal EN1 is activated and the second enable signal EN2 and the third enable signal EN3 are deactivated, the voltage regulator group RGG operates at activation level ALV 1. When the first enable signal EN1 and the second enable signal EN2 are activated and the third enable signal EN3 is deactivated, the voltage regulator group RGG operates at activation level ALV 2. When the first enable signal EN1, the second enable signal EN2, and the third enable signal EN3 are each activated, the voltage regulator group RGG operates at activation level ALV 3. As the activation level ALV increases, the quantity of voltage regulators activated in the voltage regulator group RGG increases, and accordingly, current consumption of the voltage regulator group RGG increases.

For example, the first plane voltage regulator group RGG_P1 operates in one of activation levels ALV 1 to ALV 3 according to the first enable signal EN1_P1, the second enable signal EN2_P1, and the third enable signal EN3_P1. When the first enable signal EN1_P1 is activated and the second enable signal EN2_P1 and the third enable signal EN3_P1 are deactivated, the voltage regulators 221 and 222 are activated, and the first plane voltage regulator group RGG_P1 operates at activation level ALV 1. When the first enable signal EN1_P1 and the second enable signal EN2_P1 are activated and the third enable signal EN3_P1 is deactivated, the voltage regulators 221, 222, 223, and 224 are activated, and the first plane voltage regulator group RGG_P1 operates at activation level ALV 2. When the first enable signal EN1_P1, the second enable signal EN2_P1, and the third enable signal EN3_P1 are activated, the voltage regulators 221 to 226 are activated, and the first plane voltage regulator group RGG_P1 operates at activation level ALV 3.

The second plane voltage regulator group RGG_P2 operates at one of activation levels ALV 1 to ALV 3 according to the first enable signal EN1_P2, the second enable signal EN2_P2, and the third enable signal EN3_P2 in a similar manner as described with respect to the first plane voltage regulator group RGG_P1.

The top voltage regulator group RGG_TOP operates at activation level ALV 1 or activation level ALV 3 according to the first enable signal EN1_TOP and the third enable signal EN3_TOP in a similar manner as described with respect to the first plane voltage regulator group RGG_P1. Because the top voltage regulator group RGG_TOP does not receive a second enable signal corresponding to the second enable signals EN2_P1 and EN2_P2, the top voltage regulator group RGG_TOP does not operate at activation level ALV 2, but operates at activation level ALV 1 or activation level ALV 3. In an embodiment, the top voltage regulator group RGG_TOP include voltage regulators that receive a second enable signal, in which embodiment, the top voltage regulator group RGG_TOP operates at one of activation levels ALV 1, ALV 2, and ALV 3.

In an embodiment, more than three activation levels ALV may be utilized, and additional enable signals may be used. For example, when a voltage regulator group operates at one of activation levels ALV 1 to ALV 4, voltage regulators included in the voltage regulator group receive the enable signals EN1 to EN3 and a fourth enable signal (not shown).

In an embodiment, when the memory cell array 150 includes one or more planes in addition to the first plane P1 and the second plane P2, the voltage supply circuit 120 includes one or more plane voltage regulator groups in addition to the first plane voltage regulator group RGG_P1 and the second plane voltage regulator group RGG_P2. The one or more additional plane voltage regulator groups may be configured and operate similarly to the first plane voltage regulator group RGG_P1 and the second plane voltage regulator group RGG_P2.

FIG. 3A is a circuit diagram illustrating a voltage regulator RG according to an embodiment, and FIG. 3B is a table TB2 illustrating current consumption levels CLV according to a current control signal SRE. Each of the voltage regulators RG of FIG. 2A may be configured and operate similarly to the voltage regulator RG of FIG. 3A. Each of the voltage regulators RG of FIG. 2A receives a corresponding enable signal instead of an enable signal EN and a corresponding current control signal instead of the current control signal SRE. For example, the voltage regulator 211 of FIG. 2A is configured similarly to the voltage regulator RG of FIG. 3A, receives the first enable signal EN1_TOP instead of the enable signal EN, and receives the first current control signal SRE1_TOP instead of the current control signal SRE.

Referring to FIG. 3A, the voltage regulator RG includes a comparison circuit 301, a current sink circuit 302, a stabilization circuit 303, a path circuit 304, a voltage dividing circuit 305, and an activation circuit 306.

The comparison circuit 301 receives a reference voltage VREF1 through an inverting terminal (-) and a voltage of a feedback node NDFB through a non-inverting terminal (+). The comparison circuit 301 compares the reference voltage VREF1 with the voltage of the feedback node NDFB and outputs a voltage according to a comparison result at drive node NDDRV. For example, the comparison circuit 301 decreases a voltage at the drive node NDDRV when the voltage at the feedback node NDFB is lower than the reference voltage VREF1. The comparison circuit 301 increases the voltage at the drive node NDDRV when the voltage at the feedback node NDFB is higher than the reference voltage VREF1. The comparison circuit 301 may be implemented with an operational amplifier.

The current sink circuit 302 is coupled to the comparison circuit 301 through a sink node NDS and couples the comparison circuit 301 to a ground node in response to the enable signal EN and the current control signal SRE. The current sink circuit 302 controls current flowing into the comparison circuit 301 in response to the enable signal EN and the current control signal SRE. The current sink circuit 302 includes a first sink circuit 311 to a fourth sink circuit 314. The first sink circuit 311 includes NMOS transistors coupled in series between the sink node NDS and the ground node and receive one of the enable signal EN and a bias voltage VB at each gate. The sink circuits 312 to 314 are configured similarly to the first sink circuit 311. The sink circuits 312 to 314 receive a least significant bit SRE<1>, a middle bit SRE<2>, and a most significant bit SRE<3> of the current control signal SRE, respectively, instead of the enable signal EN. This example of the current control signal SRE includes three bits.

The stabilization circuit 303 includes a capacitor C and a resistor R31 coupled in series between a power node VCC and the drive node NDDRV.

The path circuit 304 is coupled between the power node VCC and an output node NDOUT that outputs an output voltage VOUT such as a data path voltage. The path circuit 304 drives the output node NDOUT at the voltage of the power node VCC based on a voltage at the drive node NDDRV. The path circuit 304 may be implemented with a PMOS transistor. The PMOS transistor drives the output node NDOUT at the voltage of the power node VCC based on the voltage of the drive node NDDRV received through its gate.

The voltage dividing circuit 305 includes resistors R32 and R33 coupled in series between the output node NDOUT and the ground node. The voltage dividing circuit 305 divides the output voltage VOUT at the feedback node NDFB located between the resistors R32 and R33.

The activation circuit 306 is coupled between the power node VCC and the drive node NDDRV. The activation circuit 306 drives the drive node NDDRV at the voltage of the power node VCC based on a deactivated enable signal EN. Accordingly, the path circuit 304 coupled to the drive node NDDRV is deactivated, and the output voltage VOUT is not generated at voltage VCC. The activation circuit 306 separates the power node VCC from the drive node NDDRV based on an activated enable signal EN. Accordingly, the path circuit 304 coupled to the drive node NDDRV drives the output node NDOUT at the voltage of the power node VCC based on the voltage of the drive node NDDRV. The activation circuit 306 may be implemented with a PMOS transistor. The PMOS transistor separates the power node VCC from the drive node NDDRV based on the activated enable signal EN received through the gate of the transistor 306.

Referring to table TB2 in FIG. 3B, the voltage regulator RG operates in one of current consumption levels CLV 1 to CLV 8 according to the current control signal SRE while the enable signal EN is in an activated state. For example, when the current control signal SRE is input as 000, the voltage regulator RG operates at current consumption level CLV 1, such as a minimum, low, or lowest current consumption level, and when the current control signal SRE is input as 111, the voltage regulator RG operates at current consumption level CLV 8, such as a maximum, high, or highest current consumption level. As the current consumption level CLV increases, current consumption of the voltage regulator RG increases. In an embodiment, the quantity of current consumption levels CLV may be fewer than or greater than eight levels depending on configuration of the current sink circuit 302.

FIG. 4 includes a table TB3 containing group current consumption levels GCLV of a voltage regulator group RGG according to an embodiment.

Referring to FIG. 4, the group current consumption level GCLV of the voltage regulator group RGG ranges from 1 to 6, although the quantity of group current consumption levels GCLV may change depending on an embodiment. According to the group current consumption level GCLV, the activation level ALV of the voltage regulator group RGG and the current consumption level CLV of an activated voltage regulator RG within the voltage regulator group RGG are determined. For example, the group current consumption level GCLV 1, such as a minimum, low, or lowest group current consumption level, is at activation level ALV 1 and current consumption level CLV 1. The group current consumption level GCLV 6, such as a maximum, high, or highest group current consumption level, is at activation level ALV 3 and current consumption level CLV 8. In an embodiment, the activation level ALV and the current consumption level CLV corresponding to each group current consumption level GCLV may be different from the values in table TB3.

As the group current consumption level GCLV increases, current consumption of the voltage regulator group RGG increases. The top voltage regulator group RGG_TOP, the first plane voltage regulator group RGG_P1, and the second plane voltage regulator group RGG_P2 may be controlled to operate simultaneously at different group current consumption levels GCLV. The control circuit 110 determines the group current consumption level GCLV of each voltage regulator group RGG for each operation interval based on a command and an address received from the controller 10 and generates the voltage control signals VCS to control each voltage regulator group RGG based on the determination result.

For example, when the first plane voltage regulator group RGG_P1 operates at group current consumption level GCLV 2 during an operation interval, the control circuit 110 activates the first enable signal EN1_P1 and the second enable signal EN2_P1 and maintains the third enable signal EN3_P1 in a deactivated state, such that the first plane voltage regulator group RGG_P1 operates at activation level ALV 2. The control circuit 110 outputs 000 as the first current control signal SRE1_P1 and the second current control signal SRE2_P1 such that the voltage regulators 221 and 222 activated in response to the first enable signal EN1_P1 and the voltage regulators 223 and 224 activated in response to the second enable signal EN2_P1 operate at current consumption level CLV 1.

The group current consumption level GCLV of the voltage regulator group RGG is determined according to the state of a corresponding region during each operation interval.

For example, with respect to the first plane P1 and the first plane voltage regulator group RGG_P1, during an operation interval when the first plane P1 is in an active ready state, a state in which a chip enable signal included in the external control signal ECTL is activated but the first plane P1 performs no operation, the first plane voltage regulator group RGG_P1 is controlled to operate at group current consumption level GCLV 1.

During an operation interval when the first plane P1 performs a busy operation utilizing low power, the first plane voltage regulator group RGG_P1 is controlled to operate at group current consumption level GCLV 2. The busy operation includes an access operation to the first plane P1. For example, the busy operation includes a read operation that reads data from the first plane P1 to the first buffer BF1 and a program operation that programs data stored in the first buffer BF1 into the first plane P1.

During an operation interval when the first plane P1 performs a busy operation utilizing high power, such as a busy operation in addition to a predetermined internal operation, the first plane voltage regulator group RGG_P1 is controlled to operate at group current consumption level GCLV 3.

During an operation interval when the first plane P1 performs a predetermined high-speed operation at a low transmission speed, the first plane voltage regulator group RGG_P1 is controlled to operate at group current consumption level GCLV 4.

During an operation interval when the first plane P1 performs a high-speed operation at a high transmission speed, the first plane voltage regulator group RGG_P1 is controlled to operate at group current consumption level GCLV 5. Whether the high-speed operation is performed at a low transmission speed or a high transmission speed is determined under the control of the controller 10.

During a high-performance operation interval for the first plane P1, such as an interval in which the first plane P1 performs a predetermined high-speed operation or a predetermined time interval that utilizes high power, the first plane voltage regulator group RGG_P1 is controlled to operate at group current consumption level GCLV 6.

Increases in transmission speed due to technological advancements increase current consumption and current variation speed of a data path in the memory device 100. To support high-speed operations performed at high transmission speeds, increased power supply stability may be applied or utilized. Accordingly, to provide increasing load current and enhanced power supply stability, the quantity of the voltage regulators RG in the memory device 100 and the current consumption of the voltage regulator RG increases. According to an embodiment, the memory device 100 reduces current consumption by optimizing the quality of data path voltage while stably supporting high-speed operations by controlling group current consumption levels GCLV of the voltage regulator groups RGG for each operation interval based on the types of commands and addresses.

FIG. 5A is a block diagram illustrating the control circuit 110 according to an embodiment of the present disclosure, and FIG. 5B includes table TB4 including a command flag CMDFLAG and internal control signals ICTR.

Referring to FIG. 5A, the control circuit 110 includes a logic circuit 410, an input/output circuit 420, and a voltage regulator control circuit 430.

The logic circuit 410 receives the external control signal ECTR from the controller 10 and receives the command CMD and the address ADD from the input/output circuit 420. The external control signal ECTR includes a chip enable signal CE#. In response to the external control signal ECTR, the command CMD, and the address ADD, the logic circuit 410 outputs the command flag CMDFLAG to the input/output circuit 420 and outputs the internal control signals ICTR to the voltage regulator control circuit 430. The logic circuit 410 outputs the buffer control signal BCS and the decoder control signal DCS of FIG. 1 in response to the external control signal ECTR, the command CMD, and the address ADD.

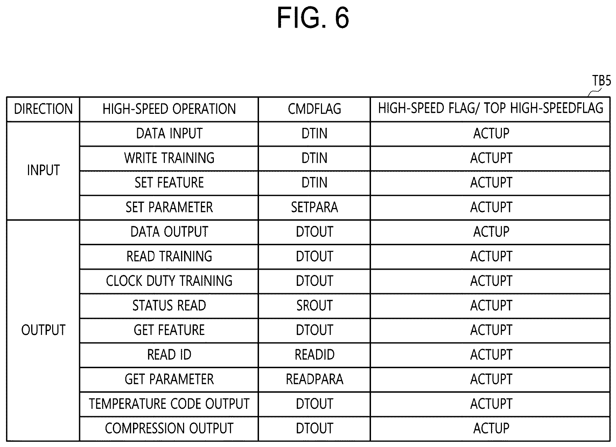

The logic circuit 410 activates a command flag CMDFLAG according to a type of the command CMD indicating a high-speed operation. The command flag CMDFLAG corresponding to the type of the command CMD is described with reference to FIG. 6.

The internal control signals ICTR include a voltage regulator enable signal RGEN, a high-speed flag ACTUP, a top high-speed flag ACTUPT, first plane selection signal SEL_P1 and second plane selection signal SEL_P2, and first plane busy signal BUSY_P1 and second plane busy signal BUSY_P2.

The logic circuit 410 activates the voltage regulator enable signal RGEN in response to the chip enable signal CE# received before the command CMD. The voltage regulator enable signal RGEN is activated while the chip enable signal CE# is in an activated state.

The logic circuit 410 activates at least one of the plane selection signals SEL_P1 and SEL_P2 in response to the command CMD and the address ADD. Each of the plane selection signals SEL_P1 and SEL_P2 is activated when the command CMD and the address ADD indicate a busy operation and/or a high-speed operation for a corresponding plane. An activated plane selection signal remains activated until a subsequent command CMD and a subsequent address ADD are received.

When the command CMD indicates a busy operation for at least one of the planes P1 and P2, the logic circuit 410 activates a plane busy signal corresponding to a plane in which the busy operation is performed among the plane busy signals BUSY_P1 and BUSY_P2 during an operation interval in which the busy operation is performed.

When the command CMD indicates a high-speed operation for at least one of the planes P1 and P2, the logic circuit 410 activates the high-speed flag ACTUP during an operation interval in which the high-speed operation is performed.

The logic circuit 410 activates the top high-speed flag ACTUPT during an operation interval in which the control circuit 110 performs a high-speed operation when the command CMD indicates a high-speed operation of the control circuit 110 without indicating a high-speed operation for any of the planes P1 and P2.

The input/output circuit 420 performs an input/output operation for the controller 10 through the input/output lines DQ coupled to the controller 10. The input/output circuit 420 receives the command CMD, the address ADD, and the data DATA from the controller 10 through the input/output lines DQ, transmits the command CMD and the address ADD to the logic circuit 410, and transmits the data DATA to the buffer circuit 130. The input/output circuit 420 transmits the data DATA received from the buffer circuit 130 to the controller 10 through the input/output lines DQ. A data path coupled to the control circuit 110 includes an input/output buffer (not shown) included in the input/output circuit 420. The input/output circuit 420 outputs a ready/busy signal RB# to the controller 10 under control of the logic circuit 410. The ready/busy signal RB# is a signal activated while the memory device 100 performs a busy operation.

The input/output circuit 420 activates a current increase signal SREEN during a high-performance operation interval according to a type of the command flag CMDFLAG received from the logic circuit 410. The high-performance operation interval may be a time interval during which high power performance is utilized or an interval during which a predetermined high-speed operation is performed. The word "predetermined" as used herein with respect to a parameter, such as a predetermined interval, time or voltage level, includes a value for the parameter determined prior to use of the parameter in a process or algorithm. In an embodiment, the value for the parameter is determined before the process or algorithm begins. In an embodiment, the value for the parameter is determined during the process or algorithm but before the parameter is used during the process or algorithm. In an embodiment, when the high-speed operation is a data input/output operation, the high-performance operation interval includes a predetermined time period before the data input/output operation starts and a predetermined time period after the data input/output operation starts. The high-performance operation interval includes an interval from a time when the data input/output operation ends until a subsequent command is received.

The voltage regulator control circuit 430 generates the voltage control signals VCS in response to the internal control signals ICTR received from the logic circuit 410 and the current increase signal SREEN received from the input/output circuit 420. The voltage regulator control circuit 430 determines, based on the internal control signals ICTR, an operation interval in which each of the control circuit 110, the first plane P1, and the second plane P2 is in an active-ready state, performs a busy operation, or performs a high-speed operation. Accordingly, the voltage regulator control circuit 430 determines the group current consumption level GCLV for each voltage regulator group RGG for each operation interval, as described with reference to FIG. 4, and generates the voltage control signals VCS corresponding to the determined group current consumption level GCLV.

The voltage regulator control circuit 430 activates the first enable signals EN1_TOP, EN1_P1, and EN1_P2 based on the voltage regulator enable signal RGEN. Accordingly, the voltage regulators 211, 212, 221, 222, 231, and 232 that receive the first enable signals EN1_TOP, EN1_P1, and EN1_P2 are activated. The voltage regulator control circuit 430 outputs the first current control signals SRE1_TOP, SRE1_P1, and SRE1_P2 as 000 in response to a deactivated high-speed flag ACTUP and a deactivated top high-speed flag ACTUPT before the command CMD is received after the chip enable signal CE# is activated, such as during an operation interval in the active-ready state. Accordingly, each of the voltage regulators 211, 212, 221, 222, 231, and 232 that receive the first current control signals SRE1_TOP, SRE1_P1, and SRE1_P2 operates at a current consumption level CLV 1. As a result, each of the voltage regulator groups RGG_TOP, RGG_P1, and RGG_P2 operates at group current consumption level GCLV 1 during an operation interval in which the control circuit 110, the first plane P1, and the second plane P2 are in the active-ready state.

The voltage regulator control circuit 430 activates a second enable signal EN2 of a target voltage regulator group corresponding to a target plane performing a busy operation, in response to an activated one of the plane selection signals SEL_P1 and SEL_P2 and an activated one of the plane busy signals BUSY_P1 and BUSY_P2. Accordingly, voltage regulators RG receiving the second enable signal EN2 in the target voltage regulator group are activated. The voltage regulator control circuit 430 outputs a first current control signal and a second current control signal SRE2 of the target voltage regulator group as 000 in response to a deactivated high-speed flag ACTUP during an operation interval in which the busy operation is performed. Accordingly, each of the voltage regulators RG that receive the current control signals SRE1 and SRE2 in the target voltage regulator group operate at current consumption level CLV 1. As a result, the target voltage regulator group operates at group current consumption level GCLV 2 during the operation interval in which the busy operation is performed for the target plane.

The voltage regulator control circuit 430 activates a second enable signal EN2 and a third enable signal EN3 of a target voltage regulator group corresponding to a target plane performing a high-speed operation, in response to an activated high-speed flag ACTUP and an activated one of the plane selection signals SEL_P1 and SEL_P2. Accordingly, each of the voltage regulators RG in the target voltage regulator group is activated. The voltage regulator control circuit 430 outputs first to third current control signals of the target voltage regulator group as 100 in response to the activated high-speed flag ACTUP and the activated plane selection signal during an operation interval in which the high-speed operation is performed. Accordingly, each of the voltage regulators RG that receive the first to third current control signals in the target voltage regulator group operates at a current consumption level CLV 5. As a result, the target voltage regulator group operates at group current consumption level GCLV 5 during the operation interval in which the high-speed operation is performed for the target plane.

The voltage regulator control circuit 430 activates a third enable signal EN3_TOP of the top voltage regulator group RGG_TOP based on an activated high-speed flag ACTUP or an activated top high-speed flag ACTUPT. Accordingly, each of the voltage regulators 211 to 216 in the top voltage regulator group RGG_TOP is activated. The voltage regulator control circuit 430 outputs a first current control signal SRE1_TOP and a third current control signal SRE3_TOP for the top voltage regulator group RGG_TOP as 100 in response to the activated high-speed flag ACTUP or the activated top high-speed flag ACTUPT. Accordingly, each of the voltage regulators 211 to 216 operates at a current consumption level CLV 5. As a result, the top voltage regulator group RGG_TOP operates at group current consumption level GCLV 5 during the operation interval in which the control circuit 110 performs the high-speed operation.

The voltage regulator control circuit 430 controls each activated voltage regulator in the target voltage regulator group to operate at current consumption level CLV 8 by outputting current control signals of the activated voltage regulators as 111 in response to the current increase signal SREEN. Accordingly, the target voltage regulator group operates at group current consumption level GCLV 6 during the corresponding operation interval.

FIG. 6 is a table TB5 including a command flag and a corresponding high-speed flag ACTUP or top high-speed flag ACTUPT according to an embodiment of the present disclosure.

Referring to FIG. 6, operations included in the column of a high-speed operation in the table TB5 include a high-speed operation performed at a high transfer speed for the controller 10. Operations corresponding to an input direction, a transfer direction from the controller 10 to the memory device 100, include a data input operation, a write training operation, a set feature operation, and a set parameter operation. Operations corresponding to an output direction, a transfer direction from the memory device 100 to the controller 10, include a data output operation, a read training operation, a clock duty training operation, a status read operation, a get feature operation, a read ID operation, a get parameter operation, a temperature code output operation, and a compression output operation.

The logic circuit 410 activates the command flag CMDFLAG according to a type of command CMD indicating a high-speed operation. For example, the logic circuit 410 activates a data input flag DTIN based on a command CMD corresponding to each of the data input operation, the write training operation, and the set feature operation. The logic circuit 410 activates a set parameter flag SETPARA based on a command CMD corresponding to the set parameter operation. The logic circuit 410 activates a data output flag DTOUT based on a command CMD corresponding to each of the data output operation, the read training operation, the clock duty training operation, the get feature operation, the temperature code output operation, and the compression output operation. The logic circuit 410 activates a status read flag SROUT based on a command CMD corresponding to the status read operation. The logic circuit 410 activates a read ID flag READID based on a command CMD corresponding to the read ID operation. The logic circuit 410 activates a get parameter flag READPARA based on a command CMD corresponding to the get parameter operation.

The logic circuit 410 activates the high-speed flag ACTUP or the top high-speed flag ACTUPT according to a type of command CMD indicating a high-speed operation. For example, the high-speed flag ACTUP is activated based on a command CMD corresponding to each of the data input operation, the data output operation, and the compression output operation. The operations activating the high-speed flag ACTUP include operations in which the control circuit and at least one plane perform a high-speed operation. The top high-speed flag ACTUPT is activated based on a command CMD corresponding to each of the write training operation, the set feature operation, the set parameter operation, the read training operation, the clock duty training operation, the status read operation, the get feature operation, the read ID operation, the get parameter operation, and the temperature code output operation. The operations activating the top high-speed flag ACTUPT include operations in which the control circuit performs a high-speed operation without a high-speed operation on any plane.

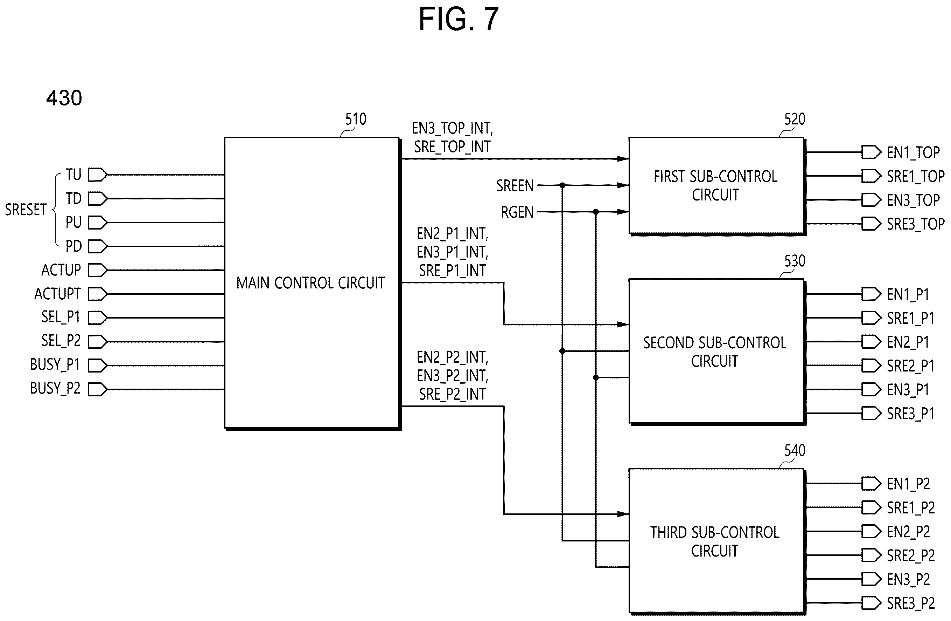

FIG. 7 is a block diagram illustrating the voltage regulator control circuit 430 according to an embodiment of the present disclosure.

Referring to FIG. 7, the voltage regulator control circuit 430 includes a main control circuit 510, a first sub-control circuit 520, a second sub-control circuit 530, and a third sub-control circuit 540.

The main control circuit 510 receives current values SRESET, the high-speed flag ACTUP, the top high-speed flag ACTUPT, the first plane selection signal SEL_P1, the second plane selection signal SEL_P2, the first plane busy signal BUSY_P1, and the second plane busy signal BUSY_P2. The main control circuit 510 outputs a third initial enable signal EN3_TOP_INT and an initial current control signal SRE_TOP_INT corresponding to the top voltage regulator group RGG_TOP. The main control circuit 510 outputs a second initial enable signal EN2_P1_INT, a third initial enable signal EN3_P1_INT, and an initial current control signal SRE_P1_INT corresponding to the first plane voltage regulator group RGG_P1. The main control circuit 510 outputs a second initial enable signal EN2_P2_INT, a third initial enable signal EN3_P2_INT, and an initial current control signal SRE_P2_INT corresponding to the second plane voltage regulator group RGG_P2. A signal output from the main control circuit 510 corresponding to a voltage regulator group indicates, for example, that the signal is used to generate voltage control signals VCS input to the corresponding voltage regulator group.

Among the current values SRESET, high current value TU and low current value TD are selectively input to the top voltage regulator group RGG_TOP as the first current control signal SRE1_TOP and the third current control signal SRE3_TOP by the voltage regulator control circuit 430. High current value PU and low current value PD among the current values SRESET are selectively input to the first plane voltage regulator group RGG_P1 and the second plane voltage regulator group RGG_P2 as first current control signals SRE1_P1 and SRE1_P2, second current control signals SRE2_P1 and SRE2_P2, and third current control signals SRE3_P1 and SRE3_P2 by the voltage regulator control circuit 430. The current values SRESET may be values stored in a register (not shown) included in the control circuit 110. The current values SRESET are set according to the current consumption levels CLV corresponding to the group current consumption levels GCLV described with reference to Table TB3. The current values SRESET may be changed under control of the controller 10 and/or the logic circuit 410. Each of the current values SRESET may include 3 bits.

The first sub-control circuit 520 receives the third initial enable signal EN3_TOP_INT, the initial current control signal SRE_TOP_INT, the current increase signal SREEN, and the voltage regulator enable signal RGEN and outputs the first enable signal EN1_TOP, the first current control signal SRE1_TOP, the third enable signal EN3_TOP, and the third current control signal SRE3_TOP to the top voltage regulator group RGG_TOP.

The second sub-control circuit 530 receives the second initial enable signal EN2_P1_INT, the third initial enable signal EN3_P1_INT, the initial current control signal SRE_P1_INT, the current increase signal SREEN, and the voltage regulator enable signal RGEN and outputs the first enable signal EN1_P1, the first current control signal SRE1_P1, the second enable signal EN2_P1, the second current control signal SRE2_P1, the third enable signal EN3_P1, and the third current control signal SRE3_P1 to the first plane voltage regulator group RGG_P1.

The third sub-control circuit 540 receives the second initial enable signal EN2_P2_INT, the third initial enable signal EN3_P2_INT, the initial current control signal SRE_P2_INT, the current increase signal SREEN, and the voltage regulator enable signal RGEN and outputs the first enable signal EN1_P2, the first current control signal SRE1_P2, the second enable signal EN2_P2, the second current control signal SRE2_P2, the third enable signal EN3_P2, and the third current control signal SRE3_P2 to the second plane voltage regulator group RGG_P2.

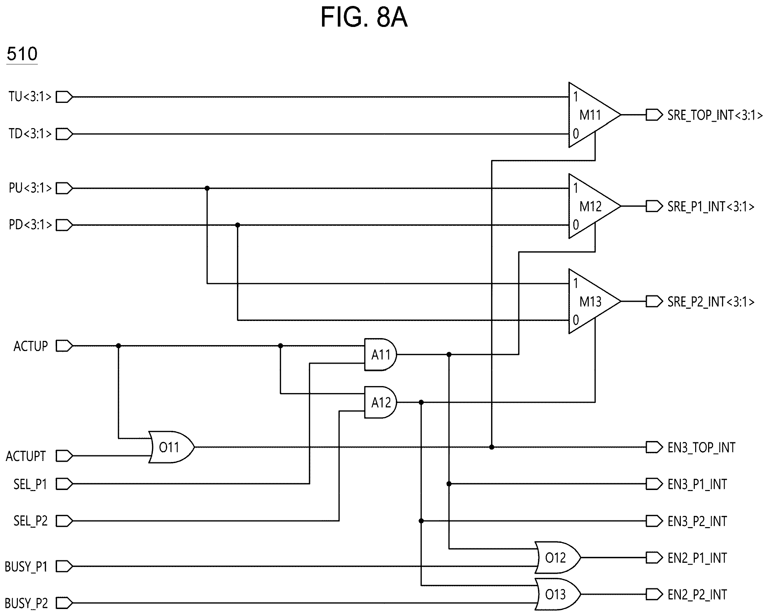

FIG. 8A to FIG. 8D are circuit diagrams illustrating the main control circuit 510 and the sub-control circuits 520 to 540 according to an embodiment of the present disclosure.

Referring to FIG. 8A, the main control circuit 510 includes a plurality of OR gates O11 to 013, a plurality of AND gates A11 and A12, and a plurality of multiplexers M11 to M13.

The OR gate O11 performs an OR operation on the high-speed flag ACTUP and the top high-speed flag ACTUPT and outputs the third initial enable signal EN3_TOP_INT.

The AND gate A11 performs an AND operation on the high-speed flag ACTUP and the first plane selection signal SEL_P1, and outputs the third initial enable signal EN3_P1_INT. The AND gate A12 performs an AND operation on the high-speed flag ACTUP and the second plane selection signal SEL_P2 and outputs the third initial enable signal EN3_P2_INT.

The OR gate 012 performs an OR operation on the third initial enable signal EN3_P1_INT and the first plane busy signal BUSY_P1 and outputs the second initial enable signal EN2_P1_INT. The OR gate 013 performs an OR operation on the third initial enable signal EN3_P2_INT and the second plane busy signal BUSY_P2 and outputs the second initial enable signal EN2_P2_INT.

The multiplexer M11 receives high current value TU<3:1> and low current value TD<3:1> and outputs one of the high current value TU<3:1> and the low current value TD<3:1> as initial current control signal SRE_TOP_INT<3:1> based on the third initial enable signal EN3_TOP_INT. For example, when the third initial enable signal EN3_TOP_INT is at a low logic level 0, the low current value TD<3:1> is output by the multiplexer M11, and when the third initial enable signal EN3_TOP_INT is at a high logic level 1, the high current value TU<3:1> is output by the multiplexer M11.

The multiplexer M12 receives high current value PU<3:1> and a low current value PD<3:1> and outputs one of the high current value PU<3:1> and the low current value PD<3:1> as initial current control signal SRE_P1_INT<3:1> based on the third initial enable signal EN3_P1_INT.

The multiplexer M13 receives the high current value PU<3:1> and the low current value PD<3:1> and outputs one of the high current value PU<3:1> and the low current value PD<3:1> as initial current control signal SRE_P2_INT<3:1> based on the third initial enable signal EN3_P2_INT.

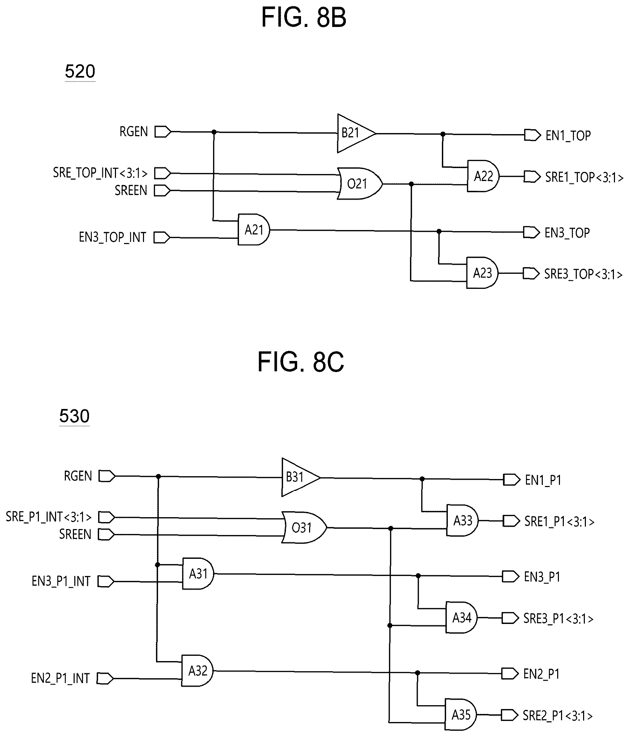

Referring to FIG. 8B, the first sub-control circuit 520 includes a buffer B21, AND gates A21 to A23, and an OR gate 021.

The buffer B21 outputs the voltage regulator enable signal RGEN as the first enable signal EN1_TOP.

The AND gate A21 performs an AND operation on the voltage regulator enable signal RGEN and the third initial enable signal EN3_TOP_INT and outputs the third enable signal EN3_TOP.

The OR gate 021 performs an OR operation on the initial current control signal SRE_TOP_INT<3:1> and the current increase signal SREEN.

The AND gate A22 performs an AND operation on an output of the OR gate 021 and the first enable signal EN1_TOP and outputs first current control signal SRE1_TOP<3:1>.

The AND gate A23 performs an AND operation on an output of the OR gate 021 and the third enable signal EN3_TOP and outputs a third current control signal SRE3_TOP<3:1>.

Referring to FIG. 8C, the second sub-control circuit 530 includes a buffer B31, AND gates A31 to A35, and an OR gate 031.

The buffer B31 outputs the voltage regulator enable signal RGEN as the first enable signal EN1_P1.

The AND gate A31 performs an AND operation on the voltage regulator enable signal RGEN and the third initial enable signal EN3_P1_INT and outputs the third enable signal EN3_P1. The AND gate A32 perform an AND operation on the voltage regulator enable signal RGEN and the second initial enable signal EN2_P1_INT and outputs the second enable signal EN2_P1.

The OR gate 031 performs an OR operation on the initial current control signal SRE_P1_INT<3:1> and the current increase signal SREEN.

The AND gate A33 performs an AND operation on an output of the OR gate 031 and the first enable signal EN1_P1 and outputs a first current control signal SRE1_P1<3:1>.

The AND gate A34 performs an AND operation on the output of the OR gate 031 and the third enable signal EN3_P1 and outputs a third current control signal SRE3_P1<3:1>.

The AND gate A35 performs an AND operation on the output of the OR gate 031 and the second enable signal EN2_P1 and outputs a second current control signal SRE2_P1<3:1>.

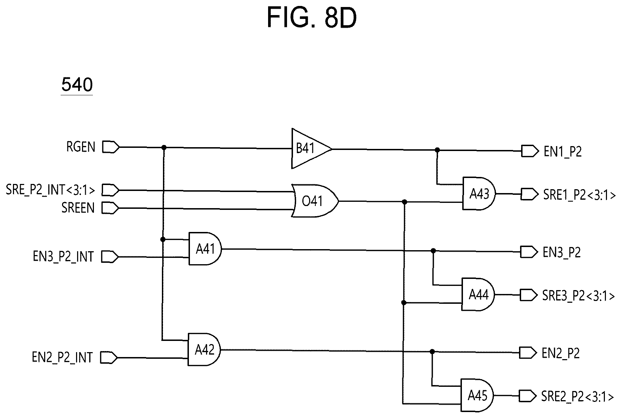

Referring to FIG. 8D, the third sub-control circuit 540 includes a buffer B41, AND gates A41 to A45, and an OR gate 041. The third sub-control circuit 540 is configured and operates similarly to the second sub-control circuit 530.

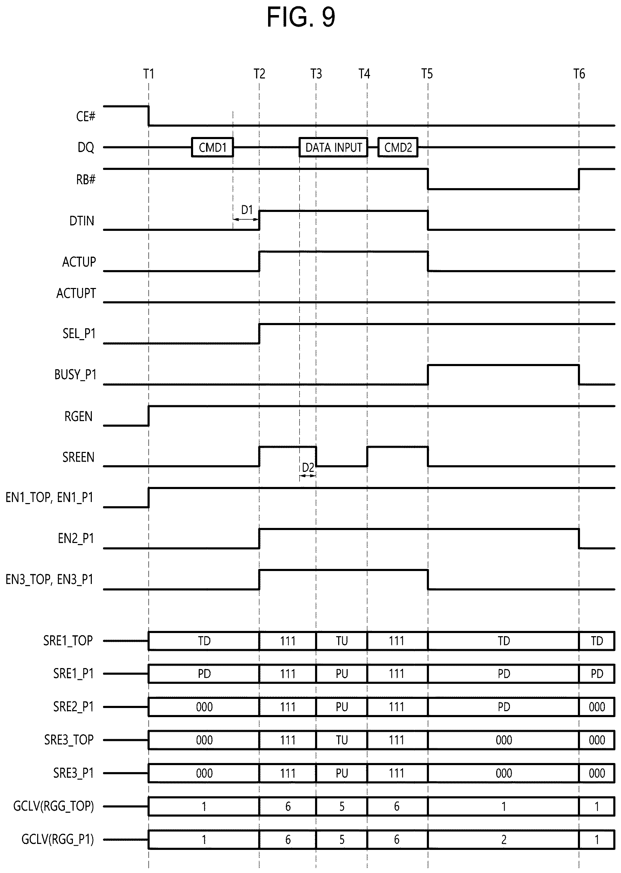

FIG. 9 is a timing diagram of a data input operation DATA INPUT according to an embodiment of the present disclosure. The data input operation DATA INPUT may be a high-speed operation as described with reference to FIG. 6. The data input operation DATA INPUT may be performed, for example, as part of a program operation. The data input operation DATA INPUT may be performed, for example, for the first plane P1. Accordingly, FIG. 9 is described with a focus on the first enable signal EN1_TOP, the third enable signal EN3_TOP, the first current control signal SRE1_TOP, and the third current control signal SRE3_TOP input to the top voltage regulator group RGG_TOP, and the first enable signal EN1_P1, the second enable signal EN2_P1, the third enable signal EN3_P1, the first current control signal SRE1_P1, the second current control signal SRE2_P1, and the third current control signal SRE3_P1 input to the first plane voltage regulator group RGG_P1.

Referring to FIG. 9, before time T1, the chip enable signal CE# is in a deactivated state, and the memory device 100 is in a standby state.

At time T1, the chip enable signal CE# is activated at a logic low level. The logic circuit 410 activates the voltage regulator enable signal RGEN at a logic high level based on the activated chip enable signal CE#. The voltage regulator control circuit 430 activates the first enable signals EN1_TOP and EN1_P1 at a logic high level in response to activation of the voltage regulator enable signal RGEN. The voltage regulator control circuit 430 outputs the low current value TD, such as 000, as the first current control signal SRE1_TOP based on the deactivated states of the high-speed flag ACTUP and the top high-speed flag ACTUPT. The voltage regulator control circuit 430 outputs the low current value PD, such as 000, as the first current control signal SRE1_P1 based on the deactivated state of the high-speed flag ACTUP. The voltage regulator control circuit 430 outputs the second enable signal EN2_P1 and the third enable signals EN3_TOP and EN3_P1 in a deactivated state at a logic low level and outputs the second current control signal SRE2_P1 and the third current control signals SRE3_TOP and SRE3_P1 as 000. Accordingly, the top voltage regulator group RGG_TOP and the first plane voltage regulator group RGG_P1 operate at group current consumption level GCLV 1 at time T1. After the chip enable signal CE# is activated, the input/output circuit 420 receives a command set CMD1 including a program command CMD and an address ADD and transmits the command set CMD1 to the logic circuit 410. The address ADD included in the command set CMD1 indicates the first plane P1.

At time T2, which occurs a predetermined time period D1 after the end of the reception of the command set CMD1, the logic circuit 410 activates the data input flag DTIN and the high-speed flag ACTUP at a logic high level based on the program command included in the command set CMD1 and activates the first plane selection signal SEL_P1 at a logic high level based on the address ADD included in the command set CMD1. The input/output circuit 420 activates the current increase signal SREEN at a logic high level based on the activated data input flag DTIN. The voltage regulator control circuit 430 activates the second enable signal EN2_P1 and the third enable signals EN3_TOP and EN3_P1 at a logic high level based on the activated high-speed flag ACTUP and the activated first plane selection signal SEL_P1 and outputs the first current control signals SRE1_TOP and SRE1_P1, the second current control signal SRE2_P1, and the third current control signals SRE3_TOP and SRE3_P1 as 111 based on the activated current increase signal SREEN. Accordingly, the top voltage regulator group RGG_TOP and the first plane voltage regulator group RGG_P1 operate at group current consumption level GCLV 6, and a data path voltage may be stably supplied in advance to a data path coupled to the control circuit 110 and a data path coupled to the first plane P1 before the data input operation DATA INPUT starts.

At time T3, which occurs a predetermined time period D2 after the data input operation DATA INPUT starts, the input/output circuit 420 deactivates the current increase signal SREEN at a logic low level. The voltage regulator control circuit 430 outputs the high current value TU, such as 100, as the first current control signal SRE1_TOP and the third current control signal SRE3_TOP based on the deactivated current increase signal SREEN and outputs the high current value PU, such as 100, as the first current control signal SRE1_P1, the second current control signal SRE2_P1, and the third current control signal SRE3_P1. Accordingly, the top voltage regulator group RGG_TOP and the first plane voltage regulator group RGG_P1 operate at group current consumption level GCLV 5 and may reduce current consumption during the data input operation DATA INPUT.

At time T4 when the data input operation DATA INPUT is completed or ended, the input/output circuit 420 activates the current increase signal SREEN at a logic high level. The voltage regulator control circuit 430 outputs the first current control signals SRE1_TOP and SRE1_P1, the second current control signal SRE2_P1, and the third current control signals SRE3_TOP and SRE3_P1 as 111 based on the activated current increase signal SREEN. Accordingly, the top voltage regulator group RGG_TOP and the first plane voltage regulator group RGG_P1 operates at group current consumption level GCLV 6 and may stably supply a data path voltage to a data path coupled to the control circuit 110 and a data path coupled to the first plane P1 in preparation for a subsequent data input operation.

At time T5 after a confirmation command CMD2 is received following the data input operation DATA INPUT, the input/output circuit 420 activates the ready/busy signal RB# at a logic low level under control of the logic circuit 410. The logic circuit 410 deactivates the data input flag DTIN and the high-speed flag ACTUP at a logic low level based on the confirmation command CMD2 transferred from the input/output circuit 420. The logic circuit 410 activates the first plane busy signal BUSY_P1 at a logic high level based on the address ADD included in the command set CMD1. The voltage regulator control circuit 430 deactivates the third enable signals EN3_TOP and EN3_P1 based on the deactivated high-speed flag ACTUP and outputs the third current control signals SRE3_TOP and SRE3_P1 as 000. The voltage regulator control circuit 430 outputs the low current value TD, such as 000, as the first current control signal SRE1_TOP based on the deactivated high-speed flag ACTUP and the top high-speed flag ACTUPT. The voltage regulator control circuit 430 outputs the low current value PD, such as 000, as the first current control signal SRE1_P1 and the second current control signal SRE2_P1 based on the deactivated high-speed flag ACTUP. Accordingly, the top voltage regulator group RGG_TOP operates at group current consumption level GCLV 1 to reduce current consumption during a busy operation, and the first plane voltage regulator group RGG_P1 operates at group current consumption level GCLV 2 to reduce current consumption while supplying a sufficient data path voltage to a data path coupled to the first plane P1 to perform the busy operation.

At time T6, the logic circuit 410 deactivates the first plane busy signal BUSY_P1 at a logic low level in response to completion or end of a busy operation on the first plane P1. The input/output circuit 420 deactivates the ready/busy signal RB# under control of the logic circuit 410. The voltage regulator control circuit 430 deactivates the second enable signal EN2_P1 at a logic low level based on the deactivated high-speed flag ACTUP signal and the first plane busy signal BUSY_P1. Accordingly, the top voltage regulator group RGG_TOP and the first plane voltage regulator group RGG_P1 operate at group current consumption level GCLV 1.

While the first plane P1 performs the program operation described with respect to FIG. 9, the second plane P2 may be in an active-ready state. The control circuit 110 controls the second plane voltage regulator group RGG_P2 to operate at group current consumption level GCLV 1.

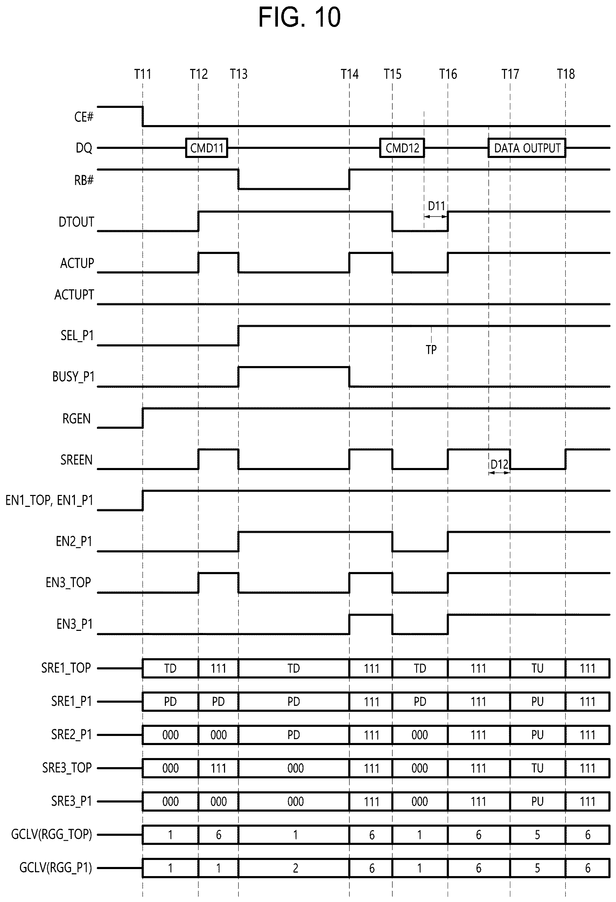

FIG. 10 is a timing diagram of a data output operation DATA OUTPUT according to an embodiment of the present disclosure. The data output operation DATA OUTPUT is a high-speed operation, as described with reference to FIG. 6. The data output operation DATA OUTPUT is performed, for example, as part of a read operation. The read operation is performed, for example, on the first plane P1. Accordingly, FIG. 10 is described with reference to the first enable signal EN1_TOP, the third enable signal EN3_TOP, the first current control signal SRE1_TOP, and the third current control signal SRE3_TOP that are input to the top voltage regulator group RGG_TOP, and the first enable signal EN1_P1, the second enable signal EN2_P1, the third enable signal EN3_P1, the first current control signal SRE1_P1, the second current control signal SRE2_P1, and the third current control signal SRE3_P1 that are input to the first plane voltage regulator group RGG_P1.

Referring to FIG. 10, before time T11, the chip enable signal CE# may be in a deactivated state, and the memory device 100 may be in a standby state.

At time T11, the chip enable signal CE# is activated at a logic low level. The logic circuit 410 activates the voltage regulator enable signal RGEN at a logic high level in response to the activated chip enable signal CE#. The voltage regulator control circuit 430 activates the first enable signals EN1_TOP and EN1_P1 based on the activated voltage regulator enable signal RGEN. The voltage regulator control circuit 430 outputs the low current value TD, such as 000, as the first current control signal SRE1_TOP based on deactivated states of the high-speed flag signal ACTUP and the top high-speed flag signal ACTUPT. The voltage regulator control circuit 430 outputs the low current value PD, such as 000, as the first current control signal SRE1_P1 based on the deactivated state of the high-speed flag signal ACTUP. The voltage regulator control circuit 430 outputs the second enable signal EN2_P1 and the third enable signals EN3_TOP and EN3_P1 in a deactivated state at a logic low level and outputs the second current control signal SRE2_P1 and the third current control signals SRE3_TOP and SRE3_P1 as 000. Accordingly, the top voltage regulator group RGG_TOP and the first plane voltage regulator group RGG_P1 operate at group current consumption level GCLV 1. After the chip enable signal CE# is activated, the input/output circuit 420 receives a command set CMD11 including a read command and an address ADD and transfers the command set CMD11 to the logic circuit 410. The address ADD included in the command set CMD11 indicates the first plane P1.

At time T12 before completion of the reception of the command set CMD11, the logic circuit 410 activates the data output flag DTOUT and the high-speed flag ACTUP at a logic high level based on the read command included in the command set CMD11. The input/output circuit 420 activates the current increase signal SREEN at a logic high level based on an activated state of the data output flag DTOUT. The voltage regulator control circuit 430 activates the third enable signal EN3_TOP at a logic high level based on the activated state of the high-speed flag ACTUP and outputs the first current control signal SRE1_TOP and the third current control signal SRE3_TOP as 111 based on the activated state of the current increase signal SREEN. Accordingly, the top voltage regulator group RGG_TOP operates at group current consumption level GCLV 6 and may stably supply a data path voltage to a data path coupled to the control circuit 110 in preparation for a high-speed operation that is subsequently performed.

At time T13 after the command set CMD11 is received, the logic circuit 410 deactivates the high-speed flag ACTUP at a logic low level based on the command set CMD11 and activates the first plane selection signal SEL_P1 and the first plane busy signal BUSY_P1 at a logic high level based on the address ADD included in the command set CMD11. The input/output circuit 420 activates the ready/busy signal RB# at a logic low level under control of the logic circuit 410 and deactivates the current increase signal SREEN at a logic low level. The voltage regulator control circuit 430 deactivates the third enable signal EN3_TOP at a logic low level and maintains the third enable signal EN3_P1 in a deactivated state at a logic low level based on the deactivated state of the high-speed flag ACTUP and outputs the third current control signals SRE3_TOP and SRE3_P1 as 000. The voltage regulator control circuit 430 outputs the low current value TD, such as 000, as the first current control signal SRE1_TOP based on the deactivated states of the high-speed flag ACTUP and the top high-speed flag ACTUPT. The voltage regulator control circuit 430 outputs the low current value PD, such as 000, as the current control signals SRE1_P1 and SRE2_P1 based on the deactivated state of the high-speed flag ACTUP. Accordingly, the top voltage regulator group RGG_TOP operates at group current consumption level GCLV 1 and may reduce current consumption during the busy operation.

The first plane voltage regulator group RGG_P1 operates at group current consumption level GCLV 2 and supplies a sufficient data path voltage to a data path coupled to the first plane P1 to perform the busy operation, while reducing current consumption during the busy operation.

At time T14, the logic circuit 410 deactivates the first plane busy signal BUSY_P1 at a logic low level in response to completion of the busy operation on the first plane P1 and activates the high-speed flag ACTUP at a logic high level. The input/output circuit 420 deactivates the ready/busy signal RB# at a logic high level and activates the current increase signal SREEN at a logic high level under control of the logic circuit 410. The voltage regulator control circuit 430 activates the third enable signals EN3_TOP and EN3_P1 at a logic high level based on the activated state of the high-speed flag ACTUP and outputs the first current control signals SRE1_TOP and SRE1_P1, the second current control signal SRE2_P1, and the third current control signals SRE3_TOP and SRE3_P1 as 111 based on the activated state of the current increase signal SREEN. Accordingly, the top voltage regulator group RGG_TOP and the first plane voltage regulator group RGG_P1 operate at group current consumption level GCLV 6 and may stably supply a data path voltage to a data path coupled to the control circuit 110 and a data path coupled to the first plane P1 when the data output operation DATA OUTPUT is performed without the command set CMD12, for example, immediately. After the ready/busy signal RB# is deactivated at a logic high level, the input/output circuit 420 receives a command set CMD12 including a data output command and an address ADD and transfers the command set CMD12 to the logic circuit 410.

At time T15 before the reception of the command set CMD12 is completed, the logic circuit 410 deactivates the data output flag DTOUT and the high-speed flag ACTUP at a logic low level based on the data output command included in the command set CMD12. The input/output circuit 420 deactivates the current increase signal SREEN at a logic low level based on the deactivated data output flag DTOUT. The voltage regulator control circuit 430 deactivates the third enable signal EN3_TOP at a logic low level and outputs the third current control signal SRE3_TOP as 000 based on the deactivated high-speed flag ACTUP and the deactivated top high-speed flag ACTUPT. The voltage regulator control circuit 430 deactivates the second enable signal EN2_P1 and outputs the second current control signal SRE2_P1 as 000 based on the deactivated high-speed flag ACTUP. The voltage regulator control circuit 430 outputs the low current value TD, such as 000, as the first current control signal SRE1_TOP based on the deactivated high-speed flag ACTUP and the deactivated top high-speed flag ACTUPT. The voltage regulator control circuit 430 outputs the low current value PD, such as 000, as the first current control signal SRE1_P1 based on the deactivated high-speed flag ACTUP. Accordingly, the top voltage regulator group RGG_TOP and the first plane voltage regulator group RGG_P1 operates at group current consumption level GCLV 1 and may reduce current consumption.

At time T16, which occurs a predetermined time period D11 after the command set CMD12 is received, the logic circuit 410 activates the data output flag DTOUT and the high-speed flag ACTUP at a logic high level based on the data output command included in the command set CMD12. The input/output circuit 420 activates the current increase signal SREEN at a logic high level based on the activated data output flag DTOUT. The voltage regulator control circuit 430 activates the second enable signal EN2_P1 and the third enable signals EN3_TOP and EN3_P1 at a logic high level based on the activated high-speed flag ACTUP and the first plane selection signal SEL_P1 and outputs the first current control signals SRE1_TOP and SRE1_P1, the second current control signal SRE2_P1, and the third current control signals SRE3_TOP and SRE3_P1 as 111 based on the activated current increase signal SREEN. Accordingly, the top voltage regulator group RGG_TOP and the first plane voltage regulator group RGG_P1 operate at group current consumption level GCLV 6, and a data path voltage may be stably supplied in advance to a data path coupled to the control circuit 110 and a data path coupled to the first plane P1 before the data output operation DATA OUTPUT starts.

At time T17, which occurs a predetermined time period D12 after the data output operation DATA OUTPUT starts, the input/output circuit 420 deactivates the current increase signal SREEN at a logic low level. The voltage regulator control circuit 430 outputs the high current value TU, such as 100, as the first current control signal SRE1_TOP and the third current control signal SRE3_TOP based on the deactivated current increase signal SREEN, and outputs the high current value PU, such as 100, as the first current control signal SRE1_P1, the second current control signal SRE2_P1, and the third current control signal SRE3_P1. Accordingly, the top voltage regulator group RGG_TOP and the first plane voltage regulator group RGG_P1 operate at group current consumption level GCLV 5 and may reduce current consumption during the data output operation DATA OUTPUT.

At time T18 when the data output operation DATA OUTPUT is completed, the input/output circuit 420 activates the current increase signal SREEN at a logic high level. The voltage regulator control circuit 430 outputs the first current control signals SRE1_TOP and SRE1_P1, the second current control signal SRE2_P1, and the third current control signals SRE3_TOP and SRE3_P1 as 111 based on the activated current increase signal SREEN. Accordingly, the top voltage regulator group RGG_TOP and the first plane voltage regulator group RGG_P1 operates at group current consumption level GCLV 6, and a data path voltage may be stably supplied in advance to a data path coupled to the control circuit 110 and a data path coupled to the first plane P1 in preparation for a subsequent operation.

While the first plane P1 performs the read operation, the second plane P2 may be in an active-ready state. The control circuit 110 controls the second plane voltage regulator group RGG_P2 to operate at group current consumption level GCLV 1.

When the address ADD included in the command set CMD12 identifies the second plane P2, the logic circuit 410 deactivates the first plane selection signal SEL_P1 and activates the second plane selection signal SEL_P2 at time TP. After time TP, the voltage regulator control circuit 430 controls the second plane voltage regulator group RGG_P2 in a manner similar to the control method for the first plane voltage regulator group RGG_P1 and controls the first plane voltage regulator group RGG_P1 to operate at group current consumption level GCLV 1.

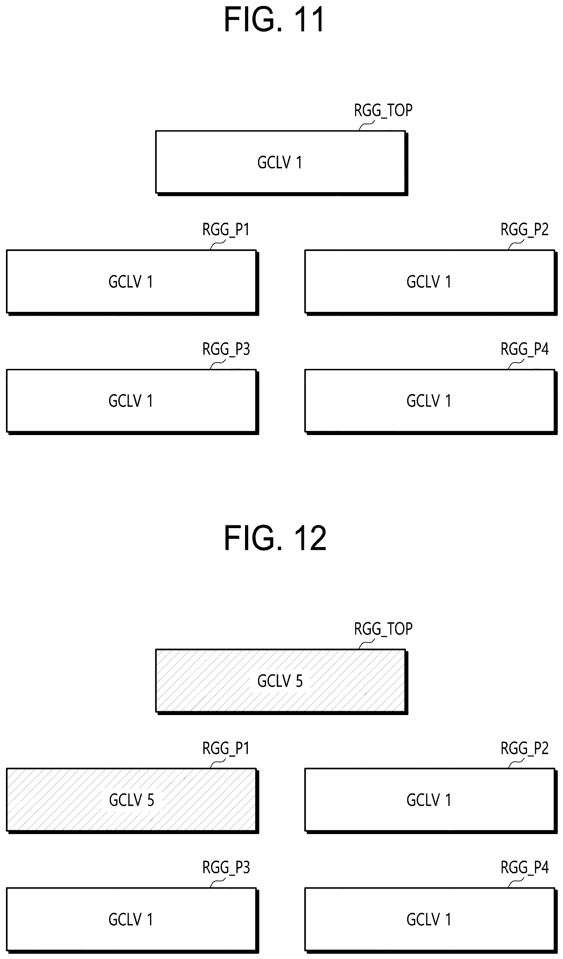

FIG. 11 to FIG. 14 are diagrams illustrating group current consumption levels GCLV for voltage regulator groups RGG_TOP, RGG_P1, RGG_P2, RGG_P3, and RGG_P4 according to an embodiment of the present disclosure. The memory device 100 may include a third plane and a fourth plane in addition to the first plane P1 and the second plane P2, for example, and may include the top voltage regulator group RGG_TOP and the plane voltage regulator groups RGG_P1 to RGG_P4.

Referring to FIG. 11, the control circuit 110 and the first to fourth planes P1 to P4 are in an active-ready state. Accordingly, the top voltage regulator group RGG_TOP and the first to fourth plane voltage regulator groups RGG_P1 to RGG_P4 operate at group current consumption level GCLV 1.

Referring to FIG. 12, the control circuit 110 and the first plane P1 perform a high-speed operation with a high transfer rate, and the planes P2 to P4 are in the active-ready state. Accordingly, the top voltage regulator group RGG_TOP and the first plane voltage regulator group RGG_P1 operate at group current consumption level GCLV 5. The plane voltage regulator groups RGG_P2 to RGG_P4 operate at group current consumption level GCLV 1.

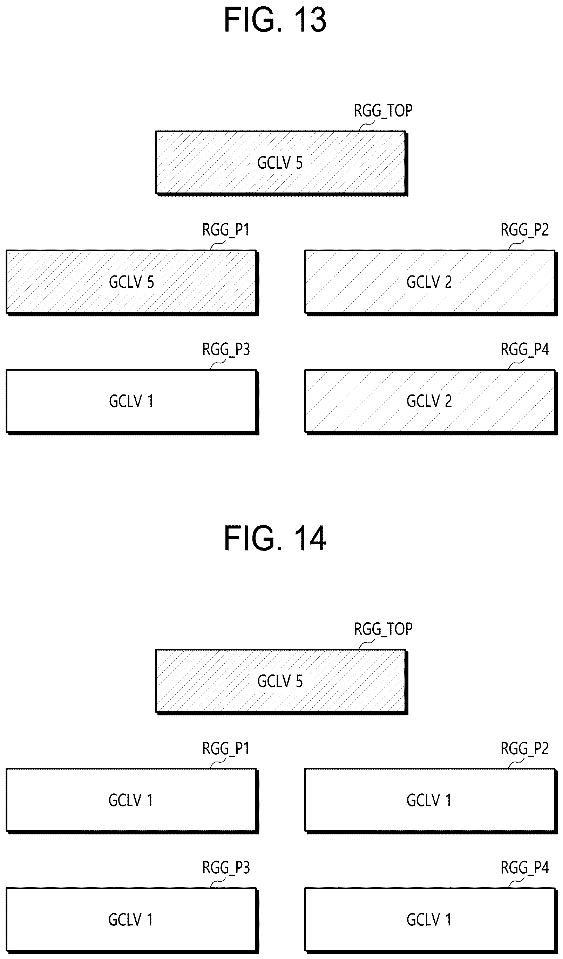

Referring to FIG. 13, the control circuit 110 and the first plane P1 perform a high-speed operation with a high transfer rate, the third plane P3 is in the active-ready state, and the planes P2 and P4 perform a busy operation. Accordingly, the top voltage regulator group RGG_TOP and the first plane voltage regulator group RGG_P1 operate at group current consumption level GCLV 5. The third plane voltage regulator group RGG_P3 operates at group current consumption level GCLV 1. The plane voltage regulator groups RGG_P2 and RGG_P4 operate at group current consumption level GCLV 2.

Referring to FIG. 14, the control circuit 110 performs a high-speed operation with a high transfer rate ( such as the set feature operation, the set parameter operation, the clock duty training operation, the status read operation, the get feature operation, the read ID operation, the get parameter operation, and the temperature code output operation), and the planes P1 to P4 are in the active-ready state. Accordingly, the top voltage regulator group RGG_TOP operates at group current consumption level GCLV 5. The plane voltage regulator groups RGG_P1 to RGG_P4 operate at group current consumption level GCLV 1.

When all the voltage regulator groups RGG_TOP, RGG_P1, RGG_P2, RGG_P3, and RGG_P4 included in the memory device 100 operate regardless of which state the control circuit 110 and the planes P1 to P4 are in or which operation they perform, excessive current may be unnecessarily consumed. For example, when the control circuit 110 and the planes P1 to P4 are in the active-ready state, when the voltage regulator groups RGG_TOP, RGG_P1, RGG_P2, RGG_P3, and RGG_P4 operate at group current consumption level GCLV 5, excessive current consumption may undesirably occur. According to an embodiment, current consumption may be reduced by controlling the group current consumption level GCLV of each voltage regulator group RGG_TOP, RGG_P1, RGG_P2, RGG_P3, and RGG_P4, for example, corresponding to regions depending on the state of the regions or which operation is performed in each operation interval.

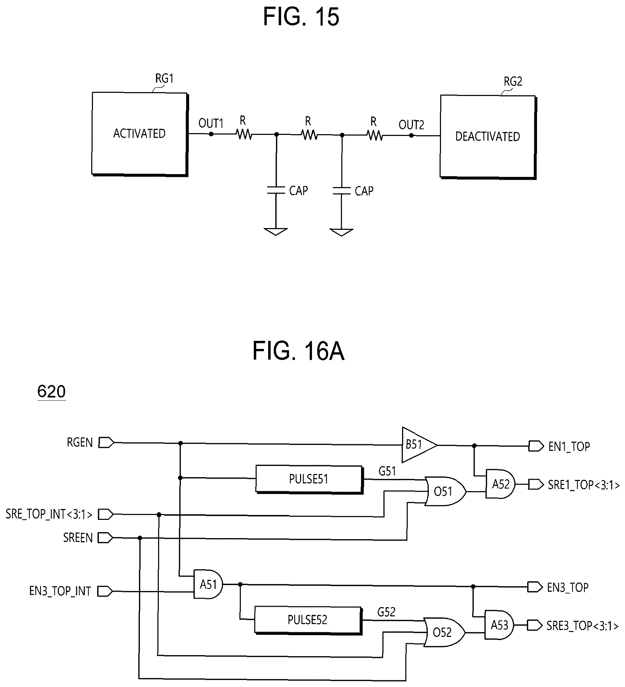

FIG. 15 is a diagram illustrating a circuit between the first voltage regulator RG1 and the second voltage regulator RG2 according to an embodiment of the present disclosure.

Referring to FIG. 15, an output node OUT1 of the first voltage regulator RG1 and an output node OUT2 of the second voltage regulator RG2 are coupled to each other through resistors R and capacitances CAP between the first voltage regulator RG1 and the second voltage regulator RG2. For example, when the second voltage regulator RG2 remains in a deactivated state and the first voltage regulator RG1 is activated, a load capacitance of the first voltage regulator RG1 is twice the load capacitance when the first voltage regulator RG1 and the second voltage regulators RG2 are activated. Accordingly, decreased circuit stability due to the increased load capacitance may result, and settling time of the first voltage regulator RG1 may increase. When a regulator is activated in response to a command and a high-speed operation is performed immediately or shortly after, a settling process of the regulator degrades power stability of a data path, and when some but not all of the regulators RG are activated, the power instability the data path may be aggravated or accelerated. According to an embodiments, when only some of the voltage regulators RG in each voltage regulator group RGG are activated, the activated voltage regulators RG may settle quickly and stably.

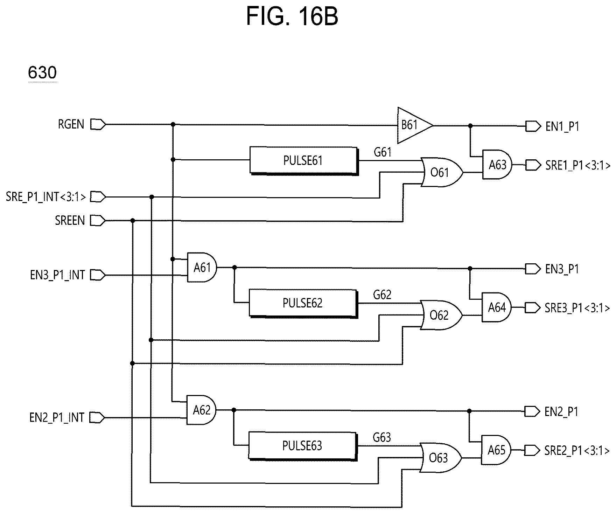

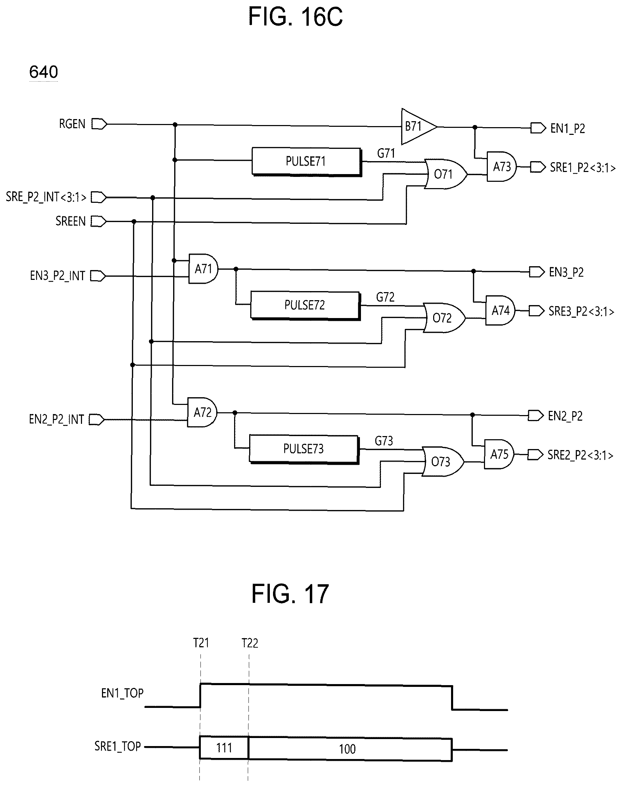

FIG. 16A is a circuit diagram illustrating a first sub-control circuit 620, FIG. 16B is a circuit diagram illustrating a second sub-control circuit 630, and FIG. 16C is a circuit diagram illustrating a third sub-control circuit 640 according to an embodiment of the present disclosure. The first sub-control circuit 620, the second sub-control circuit 630, and the third sub-control circuit 640 are included in the voltage regulator control circuit 430 instead of the first sub-control circuit 520, the second sub-control circuit 530, and the third sub-control circuit 540, respectively, of FIG. 7.

Referring to FIG. 16A, the first sub-control circuit 620 includes a buffer B51, AND gates A51 to A53, OR gates 051 and O52, and pulse generation circuits GLICH51 and GLICH52.

The buffer B51 outputs the voltage regulator enable signal RGEN as the first enable signal EN1_TOP.

The AND gate A51 performs an AND operation on the voltage regulator enable signal RGEN and the third initial enable signal EN3_TOP_INT and outputs the third enable signal EN3_TOP.

The pulse generation circuit GLICH51 generates a pulse in response to the voltage regulator enable signal RGEN and outputs a pulse signal G51. The pulse generation circuit GLICH51 outputs the pulse signal G51 including a pulse having a predetermined pulse width in response to a transition of the voltage regulator enable signal RGEN from a deactivated state to an activated state.

The pulse generation circuit GLICH52 generates a pulse in response to the third enable signal EN3_TOP and outputs a pulse signal G52. The pulse generation circuit GLICH52 outputs the pulse signal G52 including a pulse having a predetermined pulse width in response to a transition of the third enable signal EN3_TOP from a deactivated state to an activated state.

The OR gate 051 performs an OR operation on the pulse signal G51, the initial current control signal SRE_TOP_INT<3:1>, and the current increase signal SREEN. The OR gate O52 performs an OR operation on the pulse signal G52, the initial current control signal SRE_TOP_INT<3:1>, and the current increase signal SREEN.

The AND gate A52 performs an AND operation on an output of the OR gate 051 and the first enable signal EN1_TOP and outputs a first current control signal SRE1_TOP<3:1>. The AND gate A53 performs an AND operation on an output of the OR gate O52 and the third enable signal EN3_TOP and outputs a third current control signal SRE3_TOP<3:1>.

Referring to FIG. 16B, the second sub-control circuit 630 includes a buffer B61, AND gates A61 to A65, OR gates 061 to O63, and pulse generation circuits GLICH61 to GLICH63.

The buffer B61 outputs the voltage regulator enable signal RGEN as the first enable signal EN1_P1.

The AND gate A61 performs an AND operation on the voltage regulator enable signal RGEN and the third initial enable signal EN3_P1_INT and outputs the third enable signal EN3_P1. The AND gate A62 performs an AND operation on the voltage regulator enable signal RGEN and the second initial enable signal EN2_P1_INT and outputs the second enable signal EN2_P1.

The pulse generation circuit GLICH61 generates a pulse in response to the voltage regulator enable signal RGEN and outputs a pulse signal G61. The pulse generation circuit GLICH61 outputs the pulse signal G61 including a pulse having a predetermined pulse width in response to a transition of the voltage regulator enable signal RGEN from a deactivated state to an activated state.

The pulse generation circuit GLICH62 generates a pulse in response to the third enable signal EN3_P1 and outputs a pulse signal G62. The pulse generation circuit GLICH62 outputs the pulse signal G62 including a pulse having a predetermined pulse width in response to a transition of the third enable signal EN3_P1 from a deactivated state to an activated state.

The pulse generation circuit GLICH63 generates a pulse in response to the second enable signal EN2_P1 and outputs a pulse signal G63. The pulse generation circuit GLICH63 outputs the pulse signal G63 including a pulse having a predetermined pulse width in response to a transition of the second enable signal EN2_P1 from a deactivated state to an activated state.

The OR gate 061 performs an OR operation on the pulse signal G61, the initial current control signal SRE_P1_INT<3:1>, and the current increase signal SREEN. The OR gate O62 performs an OR operation on the pulse signal G62, the initial current control signal SRE_P1_INT<3:1>, and the current increase signal SREEN. The OR gate O63 performs an OR operation on the pulse signal G63, the initial current control signal SRE_P1_INT<3:1>, and the current increase signal SREEN.

The AND gate A63 performs an AND operation on an output of the OR gate 061 and the first enable signal EN1_P1 and outputs a first current control signal SRE1_P1<3:1>. The AND gate A64 performs an AND operation on an output of the OR gate O62 and the third enable signal EN3_P1 and outputs a third current control signal SRE3_P1<3:1>. The AND gate A65 performs an AND operation on an output of the OR gate O63 and the second enable signal EN2_P1 and outputs a second current control signal SRE2_P1<3:1>.

Referring to FIG. 16C, the third sub-control circuit 640 includes a buffer B71, AND gates A71 to A75, OR gates 071 to O73, and pulse generation circuits GLICH71 to GLICH73. The third sub-control circuit 640 is configured and operates similarly to the second sub-control circuit 630.

FIG. 17 is a timing diagram of the first enable signal EN1_TOP and the first current control signal SRE1_TOP output, for example, from the first sub-control circuit 620 of FIG. 16 according to an embodiment of the present disclosure.

Referring to FIG. 17, at time T21, when the first enable signal EN1_TOP is activated, the pulse generation circuit GLICH51 generates the pulse signal G51, and the first current control signal SRE1_TOP is output as 111. At time T22, the first current control signal SRE1_TOP is changed to the high current value TU, such as 100.

Accordingly, during an interval between time T21 and time T22, the voltage regulator RG operates at a current consumption level CLV 8 in response to the first enable signal EN1_TOP and the first current control signal SRE1_TOP, thereby allowing fast and stable settling. After time T22, the voltage regulator RG operates at a current consumption level CLV 5 and reduces current consumption.

The first current control signals SRE1_P1 and SRE1_P2, the second current control signals SRE2_P1 and SRE2_P2, and the third current control signals SRE3_TOP, SRE3_P1, and SRE3_P2 output from the sub-control circuits 620, 630, and 640 of FIG. 16 are generated similarly to the first current control signal SRE1_TOP. When the voltage regulator RG is activated in response to a corresponding enable signal, a corresponding current control signal is generated as 111 for a predetermined time period by a pulse circuit such that the voltage regulator RG operates at a maximum, high, or highest current consumption level. Accordingly, the voltage regulator RG may settle quickly and stably.

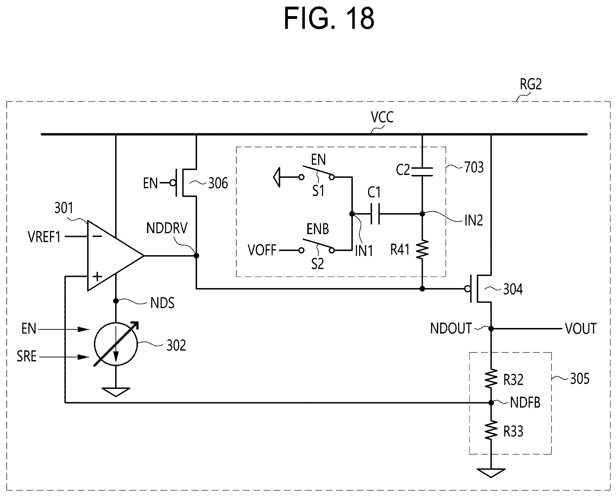

FIG. 18 is a circuit diagram of a voltage regulator RG2 according to an embodiment of the present disclosure.

Referring to FIG. 18, the voltage regulator RG2 includes a comparison circuit 301, a current sink circuit 302, a stabilization circuit 703, a path circuit 304, a voltage dividing circuit 305, and an activation circuit 306. The configuration and operation of the comparison circuit 301, the current sink circuit 302, the path circuit 304, the voltage dividing circuit 305, and the activation circuit 306 are described with reference to FIG. 3A.

The stabilization circuit 703 includes a first switch S1, a second switch S2, a first capacitor C1, a second capacitor C2, and a resistor R41. The first switch S1 is coupled between a first internal node IN1 and a ground node and performs a switching operation in response to an enable signal EN. The second switch S2 is coupled between the first internal node IN1 and a node at a deactivation voltage VOFF and performs a switching operation in response to an inverted enable signal ENB, which is an inverted signal of the enable signal EN. The deactivation voltage VOFF is greater than a ground voltage and may be lower than a voltage at power node VCC. The deactivation voltage VOFF may be a voltage reflecting a threshold voltage characteristic of the path circuit 304. In an embodiment, the deactivation voltage VOFF may vary or be modified depending on a change in the threshold voltage of the path circuit 304. The first capacitor C1 is coupled between the first internal node IN1 and a second internal node IN2. The second capacitor C2 is coupled between the power node VCC and the second internal node IN2. The resistor R41 is coupled between the second internal node IN2 and a drive node NDDRV.

When the path circuit 304 has a large parasitic capacitance, an output voltage VOUT may take a long time to settle after the voltage regulator RG2 is activated. Due to the stabilization circuit 703, a voltage of the drive node NDDRV may rapidly and stably reach a level sufficient to activate the path circuit 304, and consequently, the output voltage VOUT may settle quickly.

While the enable signal EN is in a deactivated state, the drive node NDDRV and the second internal node IN2 have a voltage level at the power node VCC, and the first internal node IN1 is at a level of the deactivation voltage VOFF. When the enable signal EN is activated, a voltage level of the first internal node IN1 is ground voltage, and accordingly, a voltage level at the second internal node IN2 decreases through charge sharing of the first capacitor C1 and the second capacitor C2. The decrease in the voltage level of the second internal node IN2 accelerates a drop in a voltage level at the drive node NDDRV, thereby enabling faster settling of the output voltage VOUT.

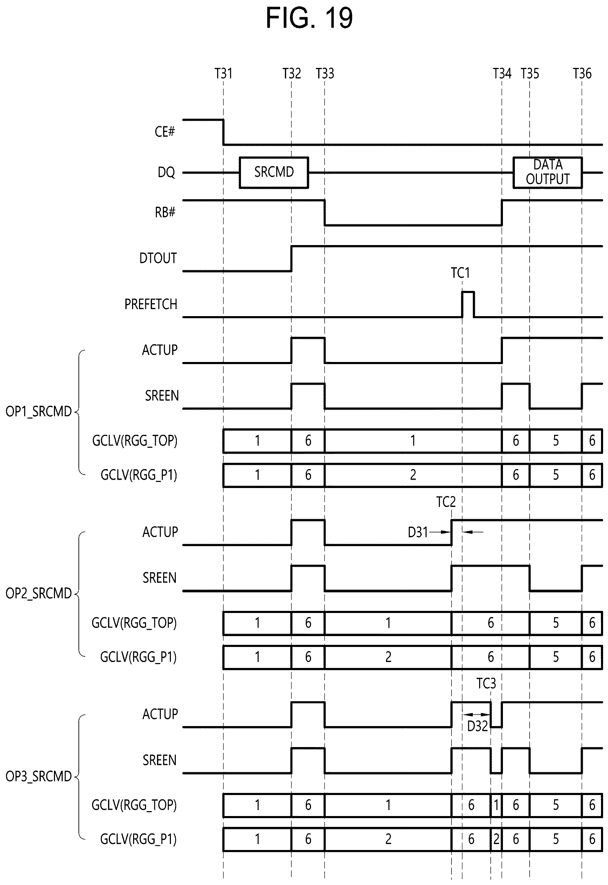

FIG. 19 is a timing diagram of a prefetch operation according to an embodiment of the present disclosure. Signals not shown in FIG. 19 may be shown in the timing diagram of FIG. 10.

In an embodiment, the logic circuit 410 activates a prefetch flag PREFETCH to indicate a prefetch operation based on a type of the command CMD. The prefetch operation includes an operation in which, while a target plane performs a busy operation, data is transferred from the target plane to a corresponding buffer, and the data is moved from the buffer to a buffer located close to the input/output lines DQ, such as an input/output buffer included in the input/output circuit 420. The prefetch operation is performed to more quickly output data to the controller 10 in response to an output command from the controller 10.

During the prefetch operation, a data path coupled to the target plane and a data path coupled to the control circuit 110 may utilize high power performance. Accordingly, the logic circuit 410 activates the high-speed flag ACTUP a predetermined time period before the prefetch flag PREFETCH is activated.

The input/output circuit 420 performs the prefetch operation in response to an activated prefetch flag PREFETCH received from the logic circuit 410. The input/output circuit 420 activates the current increase signal SREEN a predetermined time period before the prefetch flag PREFETCH is activated. That is, the operation interval in which the prefetch operation is performed is included in a high-performance operation interval. In an embodiment, the high-performance operation interval includes a predetermined time period before the prefetch operation begins and a predetermined time period after the prefetch operation starts.

Accordingly, the voltage regulator control circuit 430 controls a target voltage regulator group corresponding to the target plane to operate at group current consumption level GCLV 6 in response to the high-speed flag ACTUP and the current increase signal SREEN during an operation interval in which the target plane performs the prefetch operation.

Referring to FIG. 19, a command set SRCMD includes a read command instructing to perform a data output operation immediately or consecutively after a busy operation is performed for a target plane, for example, the first plane P1.

The high-speed flag ACTUP and the current increase signal SREEN are generated according to one of a first option OP1_SRCMD to a third option OP3_SRCMD for the command set SRCMD. According to the first option OP1_SRCMD, the chip enable signal CE#, the ready/busy signal RB#, the data output flag DTOUT, the high-speed flag ACTUP, and the current increase signal SREEN from time T31 to time T36 are generated similarly to generation of corresponding signals from time T11 to time T14 and time T17 to time T18 with reference to FIG. 10. The data output operation DATA OUTPUT is initiated in response to the command set SRCMD without receiving another command after the ready/busy signal RB# is deactivated at a logic high level. The first plane P1 performs a busy operation while the ready/busy signal RB# is activated from time T33 to time T34.

At time TC1, the logic circuit 410 activates the prefetch flag PREFETCH to instruct a prefetch operation in response to reading data from the first plane P1 to the first buffer BF1. The prefetch flag PREFETCH is activated at a logic high level as a pulse of short duration, for example. The input/output circuit 420 stores data output from the first buffer BF1 into the input/output buffer in response to the prefetch flag PREFETCH.

According to the first option OP1_SRCMD, as described with reference to FIG. 10, during the operation interval from time T33 to time T34 when the busy operation is performed, the top voltage regulator group RGG_TOP operates at group current consumption level GCLV 1, and the first plane voltage regulator group RGG_P1 operates at group current consumption level GCLV 2. At time TC1 when the prefetch operation is performed, a momentary large amount of power is consumed, and a stable supply of a data path voltage is utilized.

According to the second option OP2_SRCMD, at time TC2 that is earlier than time TC1 by a predetermined time period D31, the logic circuit 410 activates the high-speed flag ACTUP at a logic high level, and the input/output circuit 420 activates the current increase signal SREEN at a logic high level. In this example, when the prefetch operation begins in response to the prefetch flag PREFETCH at time TC1, the top voltage regulator group RGG_TOP and the first plane voltage regulator group RGG_P1 operate at group current consumption level GCLV 6. Accordingly, utilizing a sufficient power supply, the prefetch operation may be performed smoothly. At other time intervals, the operation according to the second timing option OP2_SRCMD is performed similarly to the operation according to the first option OP1_SRCMD.

According to the third option OP3_SRCMD, the logic circuit 410 activates the high-speed flag ACTUP at a logic high level, and the input/output circuit 420 activates the current increase signal SREEN at a logic high level at time TC2. The high-speed flag ACTUP is deactivated at a logic low level, and the input/output circuit 420 deactivates the current increase signal SREEN at a logic low level at time TC3 that is a time period after a predetermined time period D32 has elapsed from time TC1. The time TC3 is earlier than time T34, at which time the ready/busy signal RB# is deactivated at a logic high level. At time T34, the logic circuit 410 activates at a logic high level the high-speed flag ACTUP, and the input/output circuit 420 activates at a logic high level the current increase signal SREEN. In this example, from time TC3 to time T34, the top voltage regulator group RGG_TOP operates at group current consumption level GCLV 1, and the first plane voltage regulator group RGG_P1 operates at group current consumption level GCLV 2. Accordingly, after the prefetch operation is at least partially performed utilizing a sufficient power supply, the top voltage regulator group RGG_TOP and the first plane voltage regulator group RGG_P1 may reduce current consumption during the operation interval from time TC3 to time T34. During other time intervals, the operation according to the third option OP3_SRCMD is performed similarly to the operation according to the first option OP1_SRCMD.

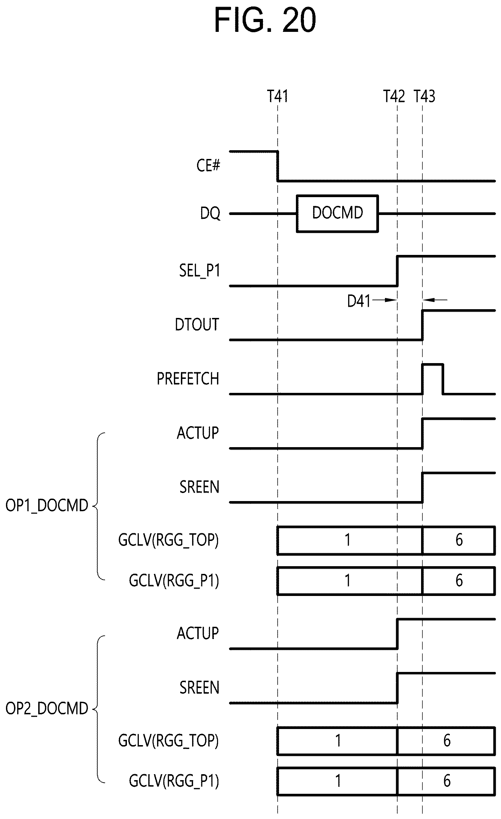

FIG. 20 is a timing diagram illustrating an operation including a prefetch operation according to an embodiment of the present disclosure. Signals not shown in FIG. 20 may be shown in the timing diagram of FIG. 10.

In an embodiment, to advance activation timing of the high-speed flag ACTUP ahead of the prefetch flag PREFETCH, the logic circuit 410 activates the high-speed flag ACTUP at a logic high level based on an address ADD following the command CMD. Accordingly, the activation timing of the high-speed flag ACTUP is advanced compared to an example in which the high-speed flag ACTUP is activated based on a confirmation command following the command CMD and the address ADD.

Referring to FIG. 20, a command set DOCMD includes a data output command instructing to perform a data output operation for data previously read from a target plane, for example, the first plane P1, and stored in the first buffer BF1.

The high-speed flag ACTUP and the current increase signal SREEN are generated according to a first option OP1_DOCMD and a second option OP2_DOCMD for the command set DOCMD. According to the first option OP1_DOCMD, at time T41, after the chip enable signal CE# is activated, the input/output circuit 420 receives the command set DOCMD and transfers the command set DOCMD to the logic circuit 410.

At time T42, the logic circuit 410 activates the first plane selection signal SEL_P1 at a logic high level based on the address ADD included in the command set DOCMD.

At time T43, the logic circuit 410 activates the data output flag DTOUT, the prefetch flag PREFETCH, and the high-speed flag ACTUP at a logic high level based on the data output command and the confirmation command included in the command set DOCMD. The confirmation command in the command set DOCMD follows the address ADD, thus time T43 is delayed from time T42 by a time period D41. The input/output circuit 420 activates the current increase signal SREEN at a logic high level based on the data output flag DTOUT. In this example, from time T43, the top voltage regulator group RGG_TOP and the first plane voltage regulator group RGG_P1 operate at group current consumption level GCLV 6. When the top voltage regulator group RGG_TOP and the first plane voltage regulator group RGG_P1 do not settle quickly, sufficient power might not be supplied at the start of the prefetch operation.

According to the second option OP2_DOCMD, at time T42, the logic circuit 410 activates the first plane selection signal SEL_P1 at a logic high level and simultaneously activates the high-speed flag ACTUP at a logic high level based on the address ADD included in the command set DOCMD. The input/output circuit 420 activates the current increase signal SREEN at a logic high level. In this example, from time T42, the top voltage regulator group RGG_TOP and the first plane voltage regulator group RGG_P1 operate at group current consumption level GCLV 6. Accordingly, before the prefetch operation begins based on the prefetch flag PREFETCH, the top voltage regulator group RGG_TOP and the first plane voltage regulator group RGG_P1 settle in advance, thereby stably supplying data path voltage during the prefetch operation.

According to the present disclosure, a memory device can reduce current consumption while reliably supporting high-speed operation.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A memory device comprising:
a plurality of planes;
a control circuit; and
a plurality of voltage regulator groups, each corresponding to one of the plurality of planes and the control circuit and configured to supply a voltage used in data transfer associated with the plurality of planes and the control circuit;
wherein the control circuit is configured to control group current consumption levels of the plurality of voltage regulator groups for each operation interval according to a command and an address.

2. The memory device of claim 1, wherein the control circuit is configured to control a first voltage regulator group, among the plurality of voltage regulator groups, corresponding to a first plane, among the plurality of planes, to operate at a higher group current consumption level than a second voltage regulator group corresponding to a second plane, among the plurality of planes, during an operation interval in which a high-speed operation is performed, when the command and the address instruct the high-speed operation of the first plane.

3. The memory device of claim 2, wherein the control circuit is configured to control a voltage regulator group, among the plurality of voltage regulator groups, corresponding to the control circuit to operate at a higher group current consumption level than the second voltage regulator group corresponding to the second plane in the operation interval in which the high-speed operation is performed.

4. The memory device of claim 1, wherein the control circuit is configured to control, during an operation interval in which a high-speed operation of the control circuit is performed, a voltage regulator group, among the plurality of voltage regulator groups, corresponding to the control circuit to operate at a higher group current consumption level than a voltage regulator group corresponding to each of the plurality of planes, when the command instructs the high-speed operation of the control circuit without instructing a high-speed operation of any plane among the plurality of planes.

5. The memory device of claim 1, wherein the control circuit is configured to control, during an operation interval in which a busy operation is performed, a voltage regulator group, among the plurality of voltage regulator groups, corresponding to a first plane, among the plurality of planes, to operate at a lower group current consumption level than during an operation interval in which a high-speed operation is performed, when the command and the address instruct the busy operation of the first plane.

6. The memory device of claim 5, wherein the control circuit is configured to control, during an operation interval in which the busy operation is performed, the voltage regulator group corresponding to the first plane to operate at a group current consumption level higher than a low group current consumption level.

7. The memory device of claim 6, wherein the control circuit is configured to control a voltage regulator group corresponding to a plane in an active ready state among the plurality of voltage regulator groups to operate at the low group current consumption level.

8. The memory device of claim 1, wherein the control circuit is configured to control the plurality of voltage regulator groups to operate at a low group current consumption level in response to a chip enable signal activated before receiving the command.

9. The memory device of claim 1, wherein the control circuit is configured to control selected voltage regulator groups among the plurality of voltage regulator groups to operate at a high group current consumption level during a high-performance operation interval based on the command.

10. The memory device of claim 9, wherein the high-performance operation interval includes a predetermined time period before a data input/output operation starts and a predetermined time period after the data input/output operation starts when the command instructs the data input/output operation.

11. The memory device of claim 10, wherein the high-performance operation interval further includes an operation interval from a time when the input/output operation ends to a time when a subsequent command is received.

12. The memory device of claim 9, wherein the high-performance operation interval includes a predetermined time period before a prefetch operation starts and a predetermined time period after the prefetch operation starts when the command instructs a data output operation.

13. The memory device of claim 1, wherein the control circuit is configured to control group current consumption level of each of the plurality of voltage regulator groups by adjusting a quantity of activated voltage regulators among a plurality of voltage regulators included in each of the plurality of voltage regulator groups and by adjusting current consumption level of each of the activated voltage regulators.

14. A memory device comprising:
a plurality of voltage regulators configured to supply a voltage used in data transfer; and
a control circuit configured to, during an operation performed in response to a command, adjust a quantity of voltage regulators activated among the plurality of voltage regulators during each operation interval of the operation.

15. A memory device comprising:
a plurality of voltage regulators configured to supply a voltage used in data transfer; and
a circuit configured to, during an operation performed in response to a command, control current consumption level of each voltage regulator activated among the plurality of voltage regulators during each operation interval of the operation.
